(19) Europäisches Patentamt
European Patent Office
Office européen des brevets

(11) **EP 4 432 802 A1**

(12) **EUROPEAN PATENT APPLICATION**
published in accordance with Art. 153(4) EPC

(43) Date of publication:
**18.09.2024 Bulletin 2024/38**

(21) Application number: **22892970.9**

(22) Date of filing: **13.07.2022**

(51) International Patent Classification (IPC):
**H10B 12/00** (2023.01)

(52) Cooperative Patent Classification (CPC):
**H10B 12/00**

(86) International application number:
**PCT/KR2022/010184**

(87) International publication number:
**WO 2023/085547 (19.05.2023 Gazette 2023/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.11.2021 KR 20210154047**

(71) Applicant: **IUCF-HYU (INDUSTRY-UNIVERSITY COOPERATION FOUNDATION HANYANG UNIVERSITY)**
**Seoul 04763 (KR)**

(72) Inventors:
• **PARK, Young Wook**
  **Seoul 04763 (KR)**
• **AHN, Jin Ho**
  **Seoul 04763 (KR)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54) **THREE-DIMENSIONAL MEMORY ARRAY AND METHOD FOR MANUFACTURING SAME**

(57)     Disclosed are a 3-dimensional memory array and a method for manufacturing the same. More specifically, a 3-dimensional memory array including isolated insulating layers and memory cell layers alternately stacked in a vertical direction and individually constructing a transistor and a capacitor includes the transistor in which a channel, and a source and a drain are respectively made of semiconductor materials with different doping concentrations, and/or the capacitor including a capacitor dielectric film with an increased opposing area size.

【Figure 4】

# Description

[Technical field]

Following embodiments relate to a 3-dimensional memory array and a method for manufacturing the same.

[Background art]

A semiconductor element such as a dynamic random access memory (DRAM) has a MOS transistor including a source and a drain, a capacitor electrically connected to the source of the MOS transistor, and wiring such as a bit line electrically connected to the drain of the MOS transistor.

In such type of DRAM, a 3-dimensional structure breaking away from a 2-dimensional structure in accordance with a trend toward high integration was proposed.

The 3-dimensional DRAM is an alternative that may overcome limitations of miniaturization and the high integration of the 2-dimensional DRAM by isolating the transistor and the capacitor from each other and individually constructing the transistor and the capacitor based on isolated insulating layers and memory cell layers stacked in an alternating manner in a vertical direction.

However, there are many technical challenges that must be overcome to implement the 3-dimensional DRAM. To maintain the basic structure of the DRAM, the single transistor and the single capacitor structure, a structure and a manufacturing method that may adjust impurity doping, which adjusts a performance of the transistor in the 3-dimensional DRAM, similar to that in the 2-dimensional DRAM are needed, and a structure and a manufacturing method in which a capacitance of the capacitor, which affects sensing margin and reliability, satisfies memory requirements are needed.

Referring to US Patent Application Publication US 2019/0006376, which discloses a 3-dimensional DRAM, a structure of one transistor and one capacitor on one memory cell (1T-1C cell) is implemented. The existing 3-dimensional DRAM disclosed in US Patent Application Publication US 2019/0006376 has a problem that it is difficult to adjust the actual performance of the transistor because the adjustment of the impurity doping in the transistor is limited, and has a problem of not meeting the capacitance required by the memory caused by a limitation in a capacitor area size because only a side surface of a capacitor contact hole is used as an opposing area size in the capacitor.

Regarding the transistor, the source connected to the capacitor and the drain connected to the bit line in the transistor must be made of silicon with high n-type impurity concentration or silicon germanium (n+ Si or SiGe) to maintain n-type low-resistance semiconductor characteristics. Moreover, a channel to connect the source and the drain to movement of electrons by forming a surface channel by an electric field in Si in contact with a gate insulating film when voltage is applied to a metal that is a gate in contact with the gate insulating film in the transistor and to electrically block the source and the drain by not forming the surface channel when no voltage is applied to the gate must be included. Such channel must be made of silicon with low p-type impurity concentration or silicon germanium (p-Si or SiGe) in a semiconductor in contact with the gate insulating film.

By including the source and the drain, and the channel formed with different doping concentrations, a performance and a regulation ability of the transistor may be improved.

However, the existing 3-dimensional DRAM disclosed in US Patent Application Publication US 2019/0006376 does not describe how the source and the drain, and the channel are formed with the different doping concentrations, and has a problem that, even when an existing technology in the 2-dimensional DRAM of simultaneously forming the source and the drain, and the channel with the same material and then performing a doping process such that the source and the drain, and the channel have the different doping concentrations is applied, because adjustment of impurity doping is limited because of a 3-dimensional structure, it is difficult to adjust the actual performance of the transistor.

Accordingly, there is a need to propose detailed technology on how to form the source and the drain, and the channel with the different doping concentrations in the 3-dimensional DRAM.

Regarding the capacitor, to have a capacitance required by the element, it is necessary to secure an opposing area size of the required capacitor. As is known, the capacitance is proportional to a dielectric constant of a dielectric film and an opposing area size between two electrodes, and is inversely proportional to a physical thickness of the dielectric film. Based on such characteristics, in the 3-dimensional DRAM, the opposing area size of the capacitor must be maximized under a condition of minimizing a thickness when stacking Si as much as possible. When the opposing area size increases and the Si stack thickness also increases, a total thickness of the 3-dimensional DRAM increases, creating a limit that higher leveling is impossible.

Such capacitor opposing area size may be calculated as Equation 1 below.

<Equation 1>

$$\text{opposing area size} = \text{diameter} * \text{pi} * \text{height}$$

When the 2-dimensional DRAM has a stacked structure where a diameter of a capacitor lower electrode is 25nm and a height is 1200nm, the opposing area of the 2-dimensional DRAM is calculated to be 94200nm2, which is a calculated value of "25*3.14*1200" according to Equation 1.

In the 3-dimensional DRAM, when it is assumed that a thickness of one silicon layer is 25nm and when the capacitor opposing area of the 3-dimensional DRAM with the same area size as the area size of the described example is calculated based on the structure disclosed in US Patent Application Publication US 2019/0006376, a value of "diameter of contact hole*pi (3.14)*height of contact hole (25nm)" may be calculated.

Therefore, for the 3-dimensional DRAM to have the same opposing area size as a capacitor opposing area size in the 2-dimensional DRAM, the diameter of the contact hole must be 1200nm. When this is calculated as an area size occupied within a cell of the 3-dimensional DRAM, it is calculated to be 1130400nm2, which is a value of "cell area size=radius2 (600nm)2*pi (3.14)".

When calculating an area size occupied within a cell of a 2D DRAM with a design rule of 15nm, it is calculated to be 1350nm2, which is a value of "area size of cell=6*F2 (F: feature size; design rule)=6*152".

As such, the 3-dimensional DRAM based on the existing structure causes an increase in cell area size by more than 800 times compared to the 2-dimensional DRAM, and thus, has a problem in that integration is lowered to meet a required capacitance.

Therefore, there is a need to propose a technology that solves the problem of the existing structure in which only a portion in contact with the electrode in the 3-dimensional DRAM is used as the capacitor.

[Disclosure]

[Technical problem]

To improve a performance of a transistor, embodiments propose a 3-dimensional memory array in which a source and a drain, and a channel are respectively made of semiconductor materials with different doping concentrations, and a method for manufacturing the same.

Moreover, to improve integration while meeting a required capacitance, embodiments propose a 3-dimensional memory array formed with a structure with an improved opposing area size and a method for manufacturing the same.

However, the technical purposes that the present disclosure seeks to achieve are not limited to the above purposes, and may be expanded in various ways without departing from the technical idea and scope of the present disclosure.

[Technical solution]

According to an embodiment, disclosed is a 3-dimensional memory array including isolated insulating layers and memory cell layers alternately stacked in a vertical direction and individually constructing a transistor and a capacitor, wherein the transistor includes a gate film extending in the vertical direction and protruding in a horizontal direction from each of the isolated insulating layers, a channel surrounding at least partial side surface of the gate film in each of the memory cell layers, and a source and a drain disposed on both sides of the gate film whose at least partial side surface is surrounded by the channel in each of the memory cell layers, wherein the channel, and the source and the drain are made of semiconductor materials with different doping concentrations, respectively.

According to one feature, the semiconductor material forming the channel and the semiconductor material forming the source and the drain may be doped with different types of impurities.

According to another feature, the 3-dimensional memory array may further include a counter doping layer disposed in portions of the source and the drain in contact with the channel, wherein the counter doping layer allows the channel to be easily formed with the semiconductor material having the different doping concentration from the semiconductor material forming the source and the drain.

According to still another feature, the doping concentration of the semiconductor material forming the channel may be adjusted depending on a thickness of the channel.

According to yet another feature, the 3-dimensional memory array may further include an ohmic film for reducing a contact resistance between the source and the drain and at least one of a bit line in contact with the source and the drain or a first electrode included in the capacitor.

According to further feature, the 3-dimensional memory array may further include a gate insulating film interposed between the gate film and the channel.

According to still further feature, the gate insulating film may be formed in an undercut shape.

According to one embodiment, disclosed is a 3-dimensional memory array including isolated insulating layers and memory cell layers alternately stacked in a vertical direction and individually constructing a transistor and a capacitor, wherein the capacitor includes a first electrode formed in a horizontal direction in each of the memory cell layers, a second electrode extending in the vertical direction and protruding in the horizontal direction in each of the isolated insulating layers, and a capacitor dielectric film formed to be in contact with the second electrode, wherein the capacitor dielectric film is formed to be in contact with the second electrode and cover a top surface, a side surface, and a bottom surface of the first electrode.

According to one feature, the first electrode may be electrically connected to a source and a drain included in the transistor in each of the memory cell layers.

According to another feature, the first electrode may be in contact with the source via an ohmic film disposed between the first electrode and the source and the drain to reduce a contact resistance.

According to one embodiment, disclosed is a method for manufacturing a transistor in a 3-dimensional memory array including isolated insulating layers and memory cell layers alternately stacked in a vertical direction including preparing a semiconductor structure including the isolated insulating layers and the memory cell layers stacked alternately in the vertical direction, wherein each of the memory cell layers is formed with a first semiconductor material, and a gate connection channel, with cells isolated in each of the memory cell layers, etching a transistor hole in the semiconductor structure in the vertical direction, recessing each of the memory cell layers in a horizontal direction via the transistor hole, selectively depositing a second semiconductor material in each of the recessed spaces such that a channel of the transistor is formed with the second semiconductor material, depositing a gate insulating film in each of the spaces where the second semiconductor material was selectively deposited, and forming a gate film in each of the spaces where the gate insulating film was deposited and in the transistor hole, wherein the second semiconductor material forming the channel has a different doping concentration from the first semiconductor material forming a source and a drain of the transistor.

According to one feature, the second semiconductor material forming the channel and the first semiconductor material forming the source and the drain may be doped with different types of impurities.

According to another feature, the recessing of each of the memory cell layers in the horizontal direction may include determining a recess depth based on a thickness of the channel formed with the second semiconductor material in each of the recessed spaces and a horizontal size of the isolated cell in each of the memory cell layers, and recessing each of the memory cell layers in the horizontal direction based on the determined depth.

According to yet another feature, the recessing of each of the memory cell layers in the horizontal direction may further include performing heat treatment on each of the recessed memory cell layers such that a counter doping layer is formed at a portion where the first semiconductor material forming the source and the drain of the transistor is in contact with the second semiconductor material forming the channel.

According to further feature, the depositing of the gate insulating film may further include depositing the gate insulating film in each of the spaces where the second semiconductor material was selectively deposited and in the transistor hole, depositing an etching protection film preventing the gate insulating film from being etched in a process of removing an etching stopper included in the semiconductor structure in the spaces where the gate insulating film was deposited and in the transistor hole, and removing the etching protection film and the gate insulating film deposited in the transistor hole such that the gate insulating film remains only in each of the spaces where the second semiconductor material was selectively deposited and removing the etching stopper using an etchback scheme to expose the gate connection channel included in the semiconductor structure.

According to still further feature, the preparing of the semiconductor structure may include preparing the semiconductor structure including the isolated insulating layers, the memory cell layers, and the gate connection channel, and etching the semiconductor structure and depositing an isolated insulating film in the etched spaces to isolate the cells in each of the memory cell layers.

According to one embodiment, disclosed is a method for manufacturing a transistor in a 3-dimensional memory array including isolated insulating layers and memory cell layers alternately stacked in a vertical direction including preparing a semiconductor structure including the isolated insulating layers and the memory cell layers stacked alternately in the vertical direction, wherein each of the memory cell layers is formed with a first semiconductor material, and a gate connection channel, with cells isolated by a second semiconductor material deposited on a side surface etched in each of the memory cell layers, wherein the second semiconductor material forms a channel of the transistor, etching a transistor hole in the semiconductor structure in the vertical direction, recessing each of the memory cell layers in a horizontal direction via the transistor hole, depositing a gate insulating film in each of the recessed spaces, and forming a gate film in each of the spaces where the gate insulating film was deposited and in the transistor hole, wherein the second semiconductor material forming the channel has a different doping concentration from the first semiconductor material forming a source and a drain of the transistor.

According to one feature, the second semiconductor material forming the channel and the first semiconductor material forming the source and the drain may be doped with different types of impurities.

According to another feature, the preparing of the semiconductor structure may include preparing the semiconductor structure including the isolated insulating layers, the memory cell layers, and the gate connection channel, and etching the semiconductor structure and depositing the second semiconductor material on the etched side surface to isolate the cells in each of the memory cell layers.

According to yet another feature, the recessing of each of the memory cell layers in the horizontal direction may include determining a recess depth such that the second semiconductor material is exposed in each of the recessed spaces based on a horizontal size of the isolated cell in each of the memory cell layers, and recessing each of the memory cell layers in the horizontal direction based on the determined depth.

According to further feature, the depositing of the gate insulating film may further include depositing the gate insulating film in each of the recessed spaces and in the transistor hole, depositing an etching protection film preventing the gate insulating film from being etched in a process of removing an etching stopper included in the semiconductor structure in the spaces where the gate insulating film was deposited and in the transistor hole, and removing the etching protection film and the gate insulating film deposited in the transistor hole such that the gate insulating film remains only in each of the recessed spaces and removing the etching stopper using an etchback scheme to expose the gate connection channel included in the semiconductor structure.

According to still further feature, the method may further include etching a bit line hole or a bit line bar in the vertical direction in an area between the isolated cells in the semiconductor structure, recessing spaces in each of the memory cell layers in the horizontal direction via the bit line hole or the bit line bar, and forming a bit line in each of the recessed spaces.

According to yet further feature, the forming of the bit line may include forming an ohmic film for reducing a contact resistance with the first semiconductor material forming the source and the drain of the transistor in each of the recessed spaces, and forming the bit line in each of the spaces where the ohmic film was formed.

According to one embodiment, disclosed is a method for manufacturing a capacitor in a 3-dimensional memory array including isolated insulating layers and memory cell layers alternately stacked in a vertical direction including preparing a semiconductor structure including the isolated insulating layers and the memory cell layers stacked alternately in the vertical direction, wherein each of the memory cell layers is formed with a first semiconductor material, and a gate connection channel, with cells isolated in each of the memory cell layers, etching a capacitor hole in the semiconductor structure in the vertical direction, removing remaining portions except for the first semiconductor material forming a source and a drain of a transistor manufactured in the semiconductor structure in each of the memory cell layers via the capacitor hole, depositing a first electrode in spaces where the remaining portions were removed, removing remaining portions except for a portion corresponding to the transistor in each of the isolated insulating layers such that a surface of the first electrode formed in each of the memory cell layers is exposed, depositing a capacitor dielectric film in each of the spaces where the remaining portions except for the portion corresponding to the transistor were removed in each of the isolated insulating layers and in the capacitor hole, and forming a second electrode in each of the spaces where the isolated insulating layers was removed and the capacitor dielectric film was deposited and in the capacitor hole where the capacitor dielectric film was deposited, wherein the capacitor dielectric film is formed to be in contact with the second electrode and cover a top surface, a side surface, and a bottom surface of the first electrode.

According to one feature, the etching of the capacitor hole in the vertical direction may include etching the capacitor hole in the vertical direction at an arbitrary location on the semiconductor structure in consideration of a thickness of the source included in the transistor manufactured in the semiconductor structure.

According to another feature, the depositing of the first electrode may include forming an ohmic film for reducing a contact resistance with the first semiconductor material forming the source and the drain of the transistor in each of the spaces where the remaining portions were removed, and depositing the first electrode in each of the spaces where the ohmic film was formed.

According to still another feature, the depositing of the first electrode may include depositing the first electrode in the spaces where the remaining portions were removed and in the capacitor hole, and removing the first electrode deposited in the capacitor hole.

According to yet another feature, the removing of the remaining portions except for the portion corresponding to the transistor in each of the isolated insulating layers may include removing the remaining portions except for the portion corresponding to the transistor in each of the isolation insulating layers via the capacitor hole or at least one additional hole etched in the semiconductor structure.

[Advantageous Effects]

The embodiments may propose the 3-dimensional memory array and the method for manufacturing the same to improve the performance of the transistor as the source and the drain, and the channel are respectively made of the semiconductor materials with the different doping concentrations.

Moreover, the embodiments may propose the 3-dimensional memory array and the method for manufacturing the same that improve the integration while meeting the required capacitance, via the structure with the improved opposing area size.

However, the effects of the present disclosure are not limited to the above effects, and may be expanded in various ways without departing from the technical idea and scope of the present disclosure.

[Description of Drawings]

FIG. 1 is a perspective view showing a 3-dimensional memory array according to an embodiment.
FIGS. 2A and 2B are perspective views showing transistors included in a 3-dimensional memory array shown in FIG. 1.
FIG. 3 is a perspective view showing a capacitor included in a 3-dimensional memory array shown in FIG. 1.
FIG. 4 is a plan view showing a 3-dimensional memory array according to an embodiment.
FIG. 5 is a cross-sectional view showing a 3-dimensional memory array shown in FIG. 4 and corresponds to a cross-section of FIG. 4 taken along a line A-A'.

FIG. 6 is a flowchart showing a method for manufacturing a transistor in a 3-dimensional memory array according to an embodiment.

FIGS. 7A to 7P are plan views showing a 3-dimensional memory array to illustrate a method for manufacturing a transistor in a 3-dimensional memory shown in FIG. 6.

FIGS. 8A to 8P are cross-sectional views showing a 3-dimensional memory array to illustrate a method for manufacturing a transistor in a 3-dimensional memory shown in FIG. 6 and correspond to cross-sections of FIGS. 7A to 7P taken along a line A-A'.

FIG. 9 is a flowchart showing a method for manufacturing a transistor in a 3-dimensional memory array according to another embodiment.

FIGS. 10A to 10G are plan views showing a 3-dimensional memory array to illustrate a method for manufacturing a transistor in a 3-dimensional memory shown in FIG. 9.

FIGS. 11A to 11G are cross-sectional views showing a 3-dimensional memory array to illustrate a method for manufacturing a transistor in a 3-dimensional memory shown in FIG. 9 and correspond to cross-sections of FIGS. 10A to 10G taken along a line A-A'.

FIG. 12 is a cross-sectional view of a 3-dimensional memory array shown in FIG. 10G taken along a line B-B'.

FIG. 13 is a flowchart showing a method for manufacturing a capacitor in a 3-dimensional memory array according to an embodiment.

FIGS. 14A to 14L are plan views showing a 3-dimensional memory array to illustrate a method for manufacturing a capacitor in a 3-dimensional memory array shown in FIG. 13.

FIGS. 15A to 15L are cross-sectional views showing a 3-dimensional memory array to illustrate a method for manufacturing a capacitor in a 3-dimensional memory array shown in FIG. 13 and correspond to cross-sections of FIGS. 14a to 14L taken along a line A-A'.

[Best mode]

Hereinafter, embodiments of the present disclosure will be described in detail with reference to the attached drawings. However, the present disclosure is not limited or restricted by the embodiments. Furthermore, like reference numerals given in the drawings indicate like elements.

Furthermore, the terms (terminology) used herein are terms used to appropriately express preferred embodiments of the present disclosure, and may vary based on the viewer's, operator's intention, or customs of the field to which the present disclosure belongs. Therefore, definitions of these terms should be made based on the contents throughout the present disclosure. For example, in the present disclosure, the singular form includes the plural form unless specifically stated in the phrase. Furthermore, as used herein, "comprises" and/or "including" does not exclude the presence or addition of at least one component, step, operation and/or element other than a component, a step, an operation and/or an element as stated. Moreover, although terms such as first and second are used herein to describe various areas, directions, shapes, and the like, such areas, directions, and shapes should not be limited by such terms. Such terms are merely used to distinguish one area, direction, or shape from another area, direction, or shape. Accordingly, a portion referred to as a first portion in one embodiment may be referred to as a second portion in another embodiment.

Furthermore, it should be understood that the various embodiments of the present disclosure are different from each other but are not necessarily mutually exclusive. For example, specific shapes, structures and characteristics as described with respect to one embodiment may be implemented in other embodiments without departing from the spirit and scope of the present disclosure. Furthermore, it should be understood that a location, an arrangement, or a configuration of an individual component in each presented embodiment may be changed without departing from the technical spirit and scope of the present disclosure.

Hereinafter, a 3-dimensional memory array, a method for manufacturing the same, and an electronic system including the same according to embodiments will be described in detail with reference to the drawings.

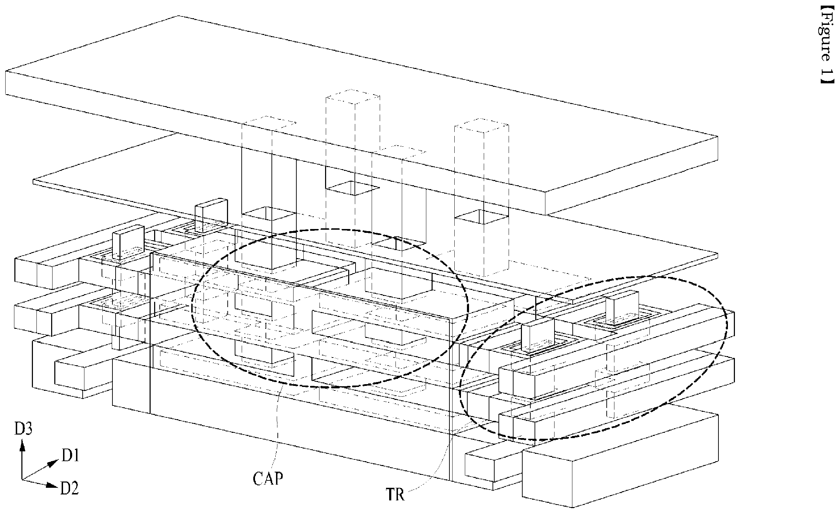

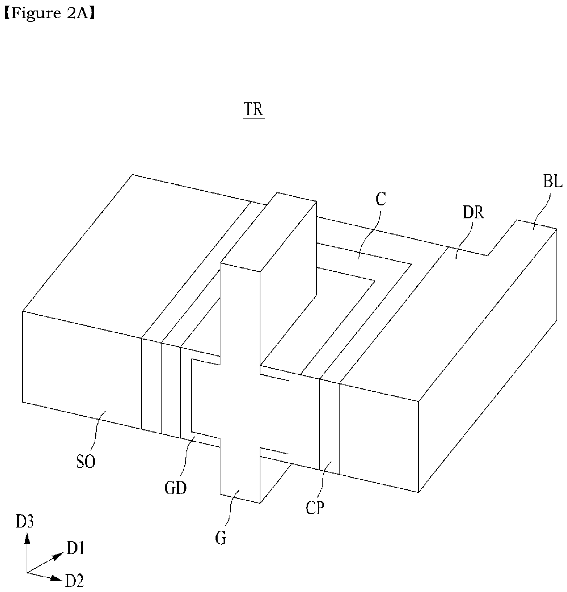

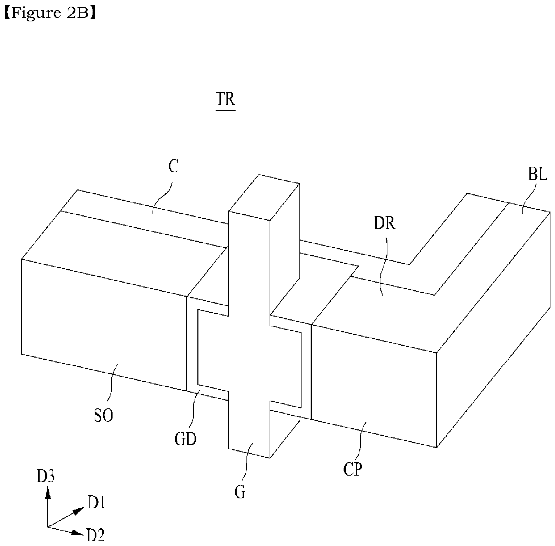

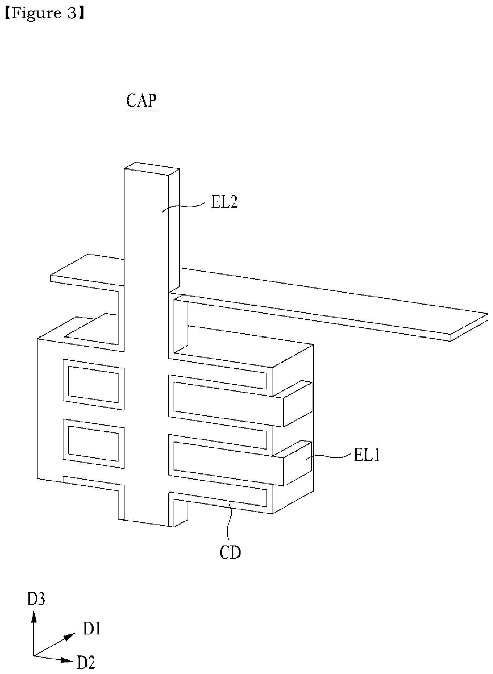

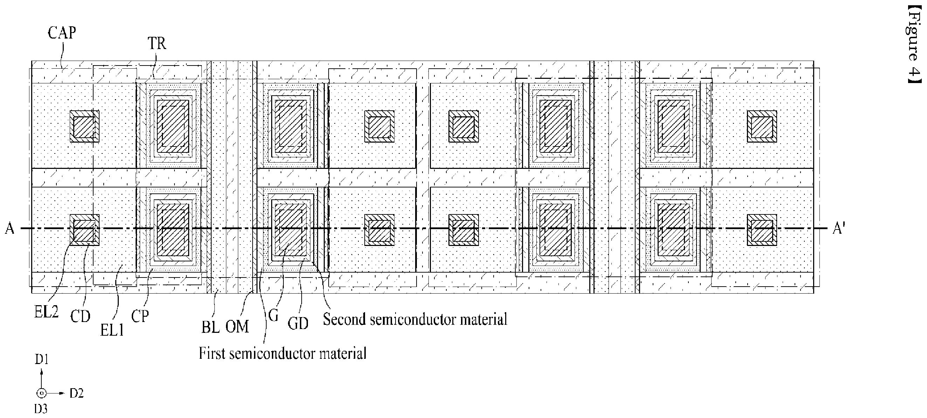

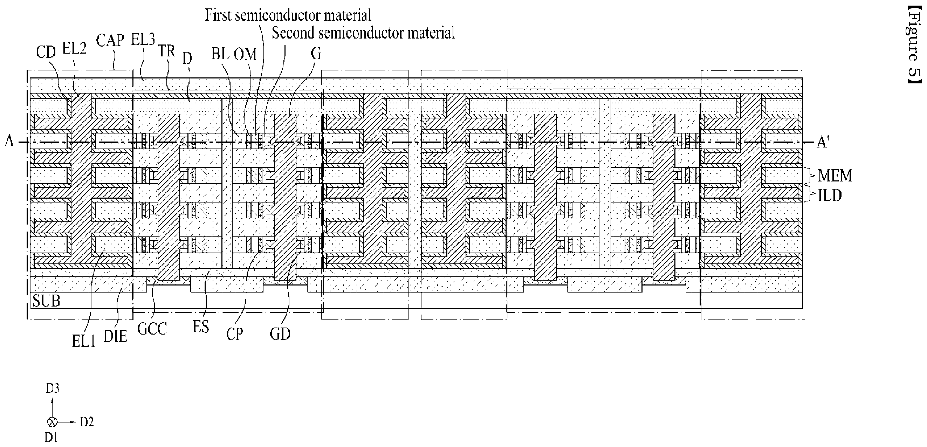

FIG. 1 is a perspective view showing a 3-dimensional memory array according to an embodiment, FIGS. 2A and 2B are perspective views showing transistors included in a 3-dimensional memory array shown in FIG. 1, FIG. 3 is a perspective view showing a capacitor included in a 3-dimensional memory array shown in FIG. 1, FIG. 4 is a plan view showing a 3-dimensional memory array according to an embodiment, FIG. 5 is a cross-sectional view showing a 3-dimensional memory array shown in FIG. 4 and corresponds to a cross-section of FIG. 4 taken along a line A-A'.

Referring to FIGS. 1 to 5, a 3-dimensional memory array according to an embodiment includes isolated insulating layers ILD and memory cell layers MEM stacked alternately in a vertical direction on a substrate SUB, and individually constructs a transistor TR and a capacitor CAP.

The substrate SUB may be a semiconductor substrate such as a silicon substrate made of monocrystalline silicon, polycrystalline silicon, or amorphous silicon, a silicon-germanium substrate, a germanium substrate, or a monocrystalline epitaxial layer grown on the monocrystalline silicon substrate. The substrate SUB may include a conductive area, for example, a well doped with impurities (e.g., P-type impurities) or an active area.

Moreover, a gate connection channel GCC connected to a gate film G may be formed in the substrate SUB via high-concentration doping. To isolate the gate connection channel GCC, an element isolating insulating film DIE may be formed surrounding the gate connection channel GCC. Moreover, an etching stopper ES to protect the silicon substrate during a manufacturing process may be formed on top of the gate connection channel GCC as an aluminum oxide film, a silicon nitride film, or the like.

Each of the isolated insulating layers ILD may be made of an insulating material such as a silicon oxide film or a silicon nitride film, and may be made of a low dielectric constant insulating material (low-k) to improve a sensing margin by reducing cells formed in the memory cell layers MEM and a capacitance of the cell.

Each of the memory cell layers MEM may include a portion (a source SO and a drain DR of the transistor TR) made of a first semiconductor material such as silicon or silicon germanium with a high n-type impurity concentration to have n-type low-resistance semiconductor characteristics, and a portion (a channel C of the transistor TR) made of a second semiconductor material such as silicon or silicon germanium with a low p-type impurity concentration to have p-type high-resistance semiconductor characteristics.

While including the gate film G, the channel C, and the source SO and the drain DR, the transistor TR may be electrically connected to a bit line BL via the drain DR and may be electrically connected to a first electrode E1 included in the capacitor CAP via the source SO.

Depending on an implementation example, the transistor TR may have a structure in which the channel C surrounds an entirety of the gate film G (more precisely, an entirety of the gate insulating film GD) on a plane as shown in FIG. 2A or may have a structure in which the channel C surrounds a portion of the gate film G on a plane (e.g., upper and lower portions of the gate film G on the plane) (more precisely, upper and lower portions of the gate insulating film GD on the plane) as shown in FIG. 2B.

The gate film G may extend in the vertical direction (e.g., a third direction D3) and may protrude in a horizontal direction (e.g., D1) in each of the isolated insulating layers ILD. The gate film G may be made of a semiconductor material (e.g., polysilicon or the like) or a conductive material (e.g., tungsten (W), copper (Cu), aluminum (Al), titanium (Ti), tantalum (Ta), molybdenum (Mo), ruthenium (Ru), gold (Au), titanium nitride, tantalum nitride, and the like).

In the transistor TR, the channel C, and the source SO and the drain DR are respectively made of semiconductor materials with different doping concentrations. Moreover, the second semiconductor material forming the channel C and the first semiconductor material forming the source SO and the drain DR are doped with different types of impurities.

More specifically, the channel C may surround at least partial side surface of the gate film G in each of the memory cell layers MEM and may be made of the second semiconductor material such as silicon or silicon germanium with the low p-type impurity concentration to have the p-type high-resistance semiconductor characteristics. In this regard, a doping concentration of the second semiconductor material forming the channel C may be adjusted depending on a thickness at which the channel C is formed.

The source SO and the drain DR may be disposed on both sides of the gate film G whose at least partial side surface is surrounded by the channel C in each of the memory cell layers MEM, and may be made of the first semiconductor material such as silicon or silicon germanium with the high n-type impurity concentration to have the n-type low-resistance semiconductor characteristics.

As such, the channel C, and the source SO and the drain DR in the transistor TR are doped with the different doping concentrations and the different types of impurities instead of being made of the same material and then formed via a doping process with different doping concentrations as in the existing technology in a 2-dimensional DRAM, thereby making the impurity doping adjustment free and improving a performance of the transistor.

In the transistor TR, as the channel C, and the source SO and the drain DR are formed with the different doping concentrations and the different types of impurities, respectively, counter doping may occur at interfaces between the channel C, and the source SO and the drain DR. Accordingly, in portions of the source SO and the drain DR that are in contact with the channel C, a counter doping layer CP that allows the channel C to be easily formed with the second semiconductor material with a doping concentration different from that of the first semiconductor material that forms the source SO and the drain DR. For example, the p-type substituted counter doping layer CP may be disposed on the respective interfaces of the source SO and the drain DR that are in contact with the channel C.

Moreover, the transistor TR may further include an ohmic film OM to reduce a contact resistance between at least one of the bit line BL in contact with the source SO and the drain DR and a first electrode EL1 included in the capacitor CAP, and the source SO and the drain DR. The ohmic film OM may be made of a single metal including tungsten, molybdenum, cobalt, titanium, nickel, ruthenium, and the like or metal silicide formed by a reaction of the single metal with silicon, using a selective ALD or CVD scheme. For example, as the ohmic film OM, ohmic silicide formed by heat treatment of cobalt, nickel, or the like may be used. For a more specific example, cobalt silicide formed by performing primary heat treatment between 150°C and 250°C and then performing secondary heat treatment between 500°C and 650°C on cobalt may be used as the ohmic film OM, and cobalt that did not react in the heat treatment may be removed via wet etching using sulfuric acid, hydrogen peroxide, and the like.

Moreover, the transistor TR may further include the gate insulating film GD interposed between the gate film G and the channel C and made of an insulating material that has insulating properties like a dielectric (e.g., a high dielectric constant material (high-k) such as a silicon oxide film, a silicon nitride film, an aluminum oxide film, and hafnium oxide). In this regard, the gate insulating film GD may be formed in an undercut shape.

The capacitor CAP may include the first electrode EL1, a second electrode EL2, and a capacitor dielectric film CD.

The first electrode EL1 may be formed in the horizontal direction (e.g., the D1) in each of the memory cell layers MEM and made of a semiconductor material (e.g., polysilicon and the like) or a conductive material (e.g., tungsten (W), copper (Cu), aluminium (Al), titanium (Ti), tantalum (Ta), molybdenum (Mo), ruthenium (Ru), gold (Au), titanium nitride, tantalum nitride, and the like). As a formation scheme, the ALD or CVD scheme or the like may be used.

In this regard, the first electrode EL1 may be electrically connected to the source SO and the drain DR included in the transistor TR in each of the memory cell layers MEM. In one example, the first electrode EL1 may be in contact with the source SO via the ohmic film OM disposed between the first electrode EL1 and the source SO and the drain DR to reduce the contact resistance.

The second electrode EL2 may be made of a semiconductor material (e.g., polysilicon and the like) or a conductive material (e.g., tungsten (W), copper (Cu), aluminium (Al), titanium (Ti), tantalum (Ta), molybdenum (Mo), ruthenium (Ru), gold (Au), titanium nitride, tantalum nitride, and the like), extend in the vertical direction (e.g., the third direction D3), and protrude in the horizontal direction (e.g., the first direction D1 and the second direction D2) in each of the isolated insulating layers ILD. As a formation scheme, the ALD or CVD scheme or the like may be used.

The capacitor dielectric film CD may be in contact with the second electrode EL2 and may be made of an insulating material that has insulating properties like a dielectric (e.g., a silicon nitride film, aluminum oxide, hafnium oxide, zirconium oxide, and the like) or a mixture thereof.

In particular, the capacitor dielectric film CD may be in contact with the second electrode EL2 having a concavo-convex shape and may be formed to cover a top surface, a side surface, and a bottom surface of the first electrode EL1, thereby having a structure with an improved opposing area size. In more detail, the opposing area size of the capacitor dielectric film CD according to an embodiment may be calculated as Equation 2 below.

opposing area size=upper and lower portion area sizes of first electrode+side surface area size of contact hole+side surface area size of first electrode

Assuming that a thickness of the memory cell layers MEM where the first electrode EL1 is disposed is 25nm and a length of one surface of the contact hole is 50nm, the opposing area size of the capacitor dielectric film CD according to an embodiment may be calculated as a value of "$2*(A2-502)+4*50*25+3*A*25=2*A2+75*A$" (here, A refers to a length of one side of the first electrode EL1 after expanding the area size).

For the capacitor dielectric film CD according to an embodiment to have the same opposing area size as an opposing area size in the above-described 2-dimensional DRAM, the value of "$2*A2+75*A$" must be 94200nm2, so that the length of the one side of the first electrode EL1 may be calculated to be approximately 200nm, and accordingly, a cell of the capacitor CAP may be implemented with an area size of 40000nm2.

Comparing this to an area size of a capacitor cell of an existing 3-dimensional DRAM, which is 1130400nm2, the cell of the capacitor CAP according to an embodiment may have an area size of 1/30 of that of the existing 3-dimensional DRAM and may be manufactured with a size equal to or smaller than 20% of a design rule.

Therefore, a required capacitance may be met while integration may be improved.

Hereinafter, a method for manufacturing the described 3-dimensional memory array will be disclosed. For convenience of description, respective manufacturing methods of the transistor TR and the capacitor CAP included in the 3-dimensional memory array will be separately described.

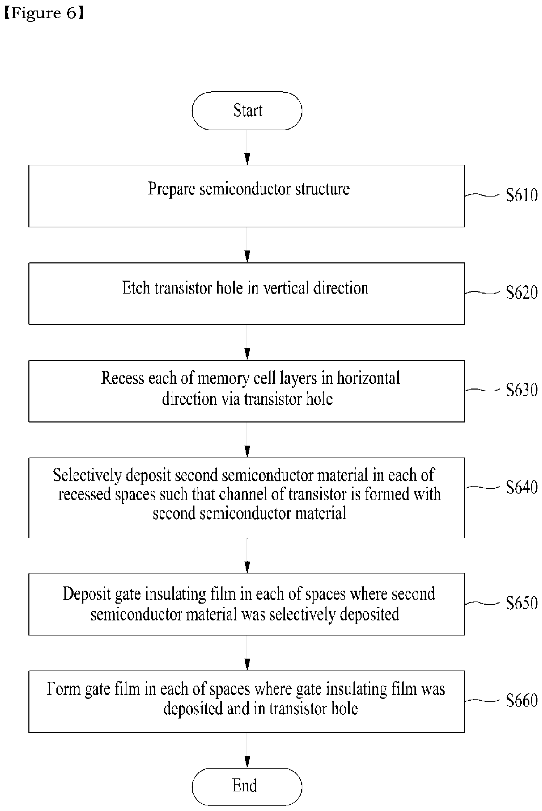

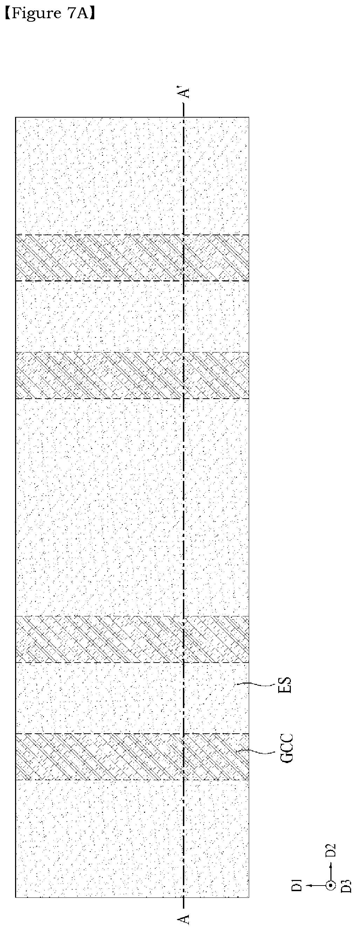

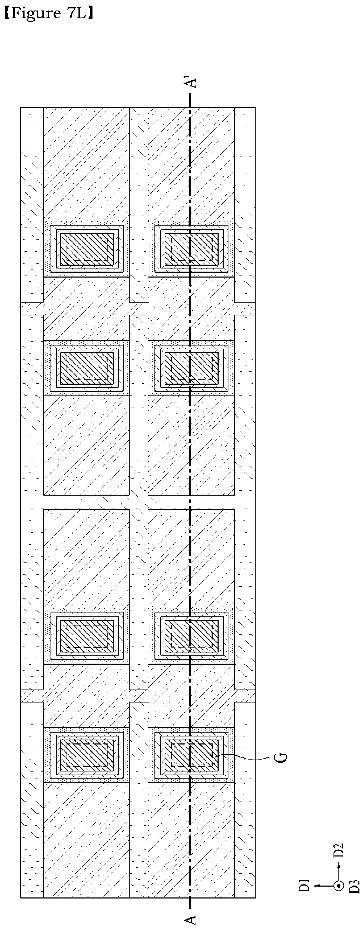

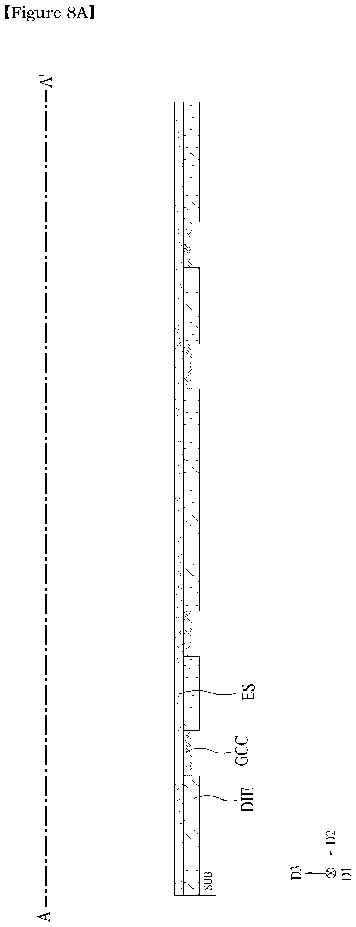

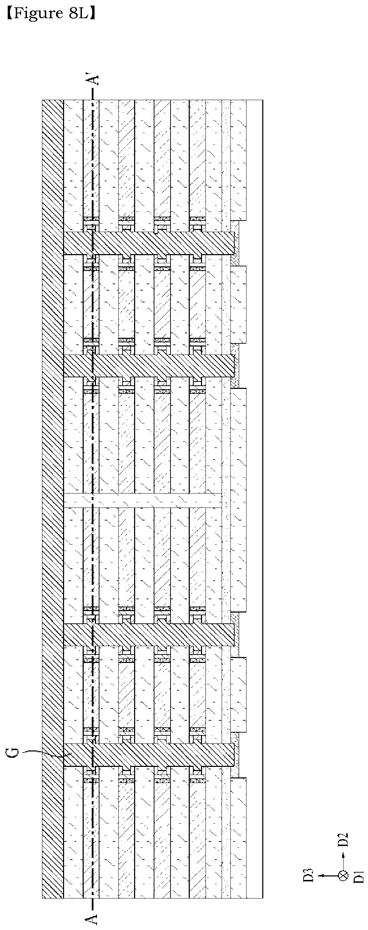

FIG. 6 is a flowchart showing a method for manufacturing a transistor in a 3-dimensional memory array according to an embodiment, FIGS. 7A to 7P are plan views showing a 3-dimensional memory array to illustrate a method for manufacturing a transistor in a 3-dimensional memory shown in FIG. 6, and FIGS. 8A to 8P are cross-sectional views showing a 3-dimensional memory array to illustrate a method for manufacturing a transistor in a 3-dimensional memory shown in FIG. 6 and correspond to cross-sections of FIGS. 7A to 7P taken along a line A-A'. The method for manufacturing the transistor in the 3-dimensional memory array to be described below is for manufacturing the transistor TR included in the 3-dimensional memory array with the structure described with reference to FIGS. 1 to 5 and is assumed to be performed by an automated and mechanized manufacturing system.

Referring to FIG. 6, in step S610, the manufacturing system may prepare a semiconductor structure SEMI-STR including the isolated insulating layers ILD and the memory cell layers MEM stacked alternately in the vertical direction and the gate connection channels GCC and having a state in which the cells are isolated in each of the memory cell layers MEM.

In this regard, each of the memory cell layers MEM may be made of the first semiconductor material such as silicon or silicon germanium with the high n-type impurity concentration to have the n-type low-resistance semiconductor characteristics, and each of the isolated insulating layers ILD may be made of the insulating material (e.g., the low-k) such as the silicon oxide film or the silicon nitride film.

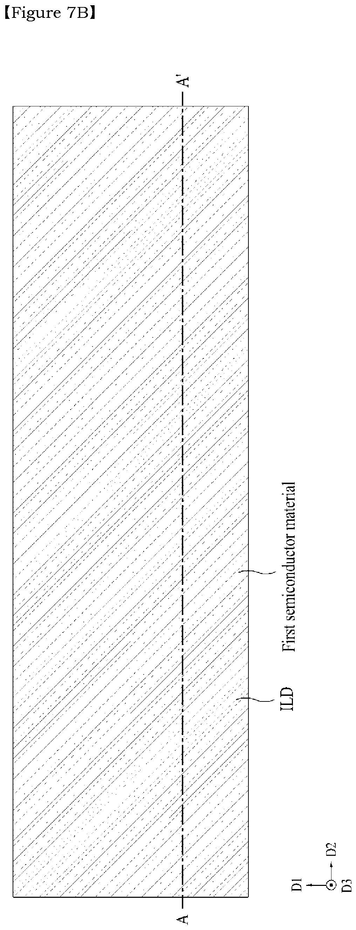

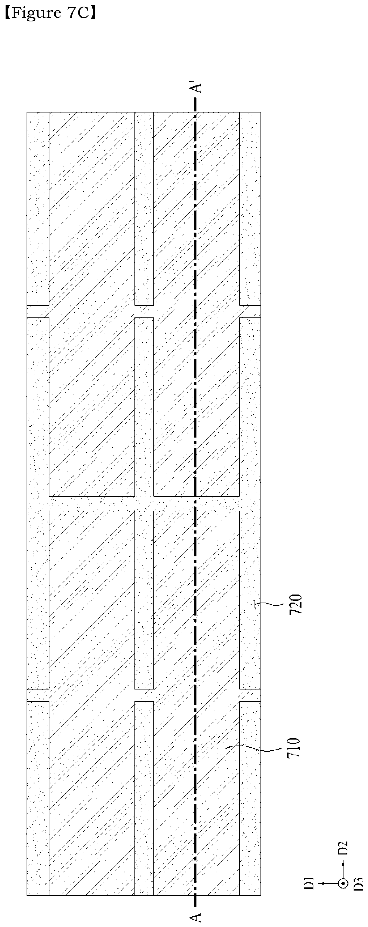

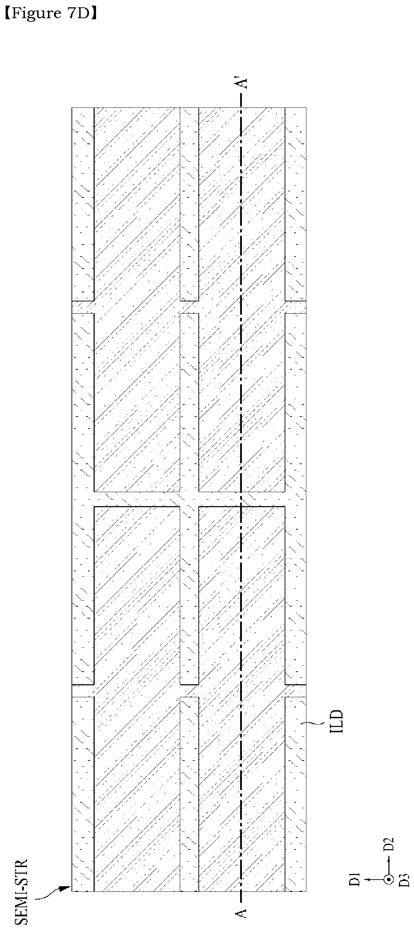

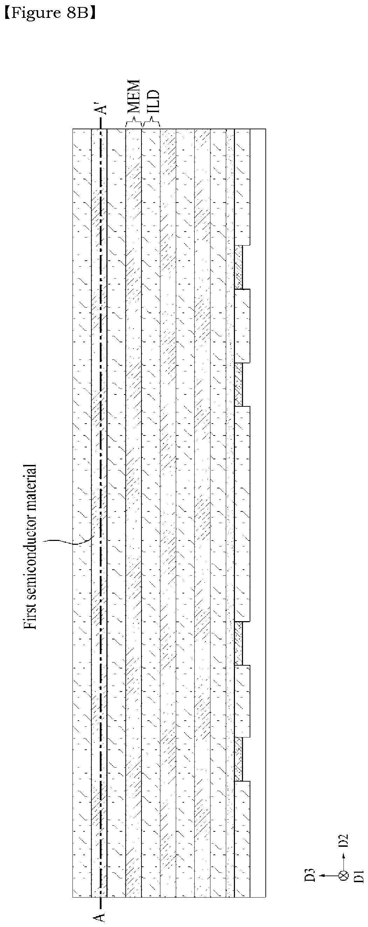

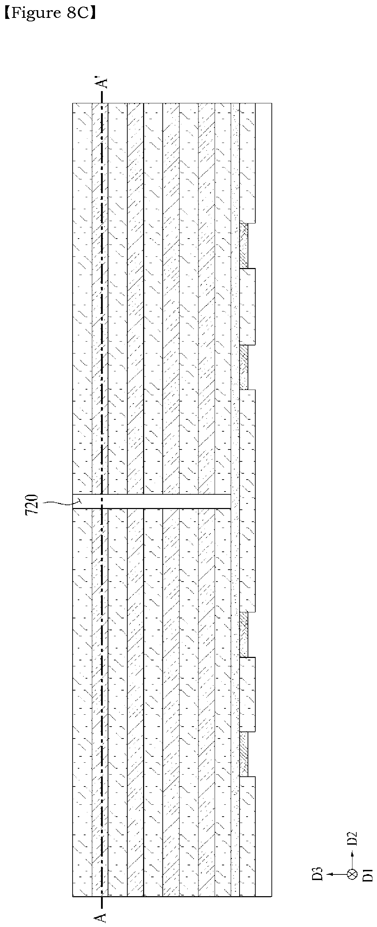

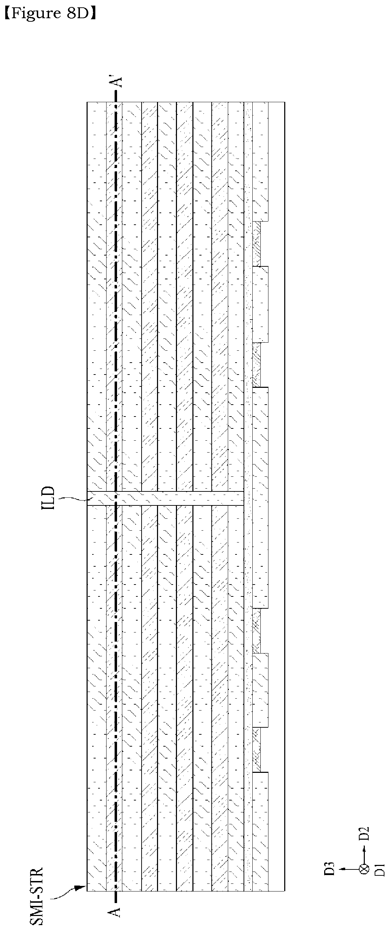

More specifically, in step S610, the manufacturing system may prepare the substrate SUB including the gate connection channel GCC as shown in FIGS. 7A and 8A and then alternately deposit and stack the isolated insulating layers ILD and the memory cell layers MEM on the substrate SUB using the CVD scheme or the like as shown in FIGS. 7B and 8B. Subsequently, the manufacturing system may prepare the semiconductor structure SEMI-STR by etching remaining portions, leaving a cell portion 710 in the semiconductor structure SEMI-STR to isolate the cell in each of the memory cell layers MEM as shown in FIGS. 7C and 8C, and depositing the isolated insulating layer ILD in spaces 720 where the remaining portions were etched as shown in FIGS. 7D and 8D.

The reason for constructing the remaining portions as the isolated insulating layer ILD while leaving the cell portion 710 in the semiconductor structure SEMI-STR is to secure a space for forming the bit line BL that is electrically connected to the drain DR, as will be explained later.

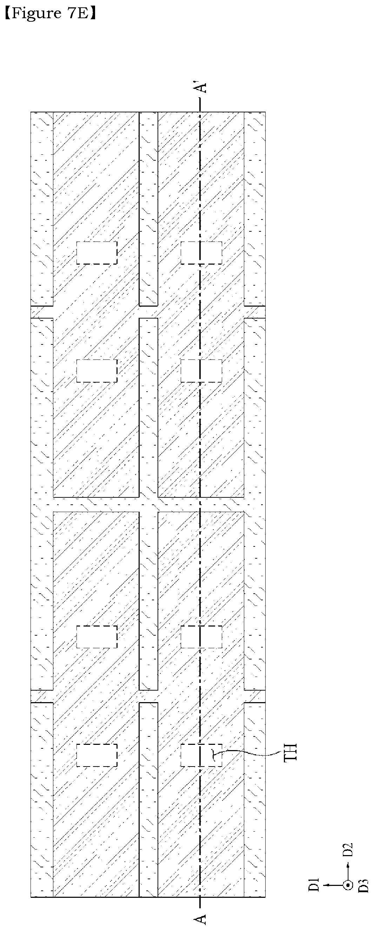

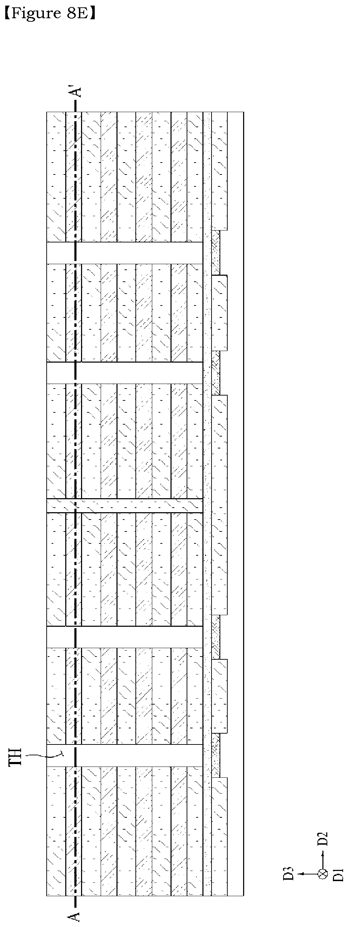

In step S620, the manufacturing system may etch a transistor hole TH in the vertical direction (e.g., the D3) in the semiconductor structure SEMI-STR, as shown in FIGS. 7E and 8E. Hereinafter, the transistor hole TH refers to a contact hole in which the gate film G is formed.

When the transistor hole TH is etched, a horizontal etching size in the second direction D2 among the horizontal directions is important. The horizontal etching size of the transistor hole TH may be determined by considering a size of a space 730 in which each of the memory cell layers MEM, which will be described later, was recessed in the horizontal direction (e.g., the first direction D1 and the second direction D2) and a horizontal size of the isolated cell in the semiconductor structure SEMI-STR. For example, the horizontal etching size of the transistor hole TH may be determined to be a size that secures the space 730 in which each of the memory cell layers MEM was recessed under a condition of not leaving the inside of the cell in the semiconductor structure SEMI-STR such that the counter doping layer CP, the second semiconductor material of the channel C, and the gate insulating film GD may be formed in the space 730 where each of the memory cell layers MEM was recessed. For example, it is appropriate that the horizontal etching size of the transistor hole TH is around 40nm.

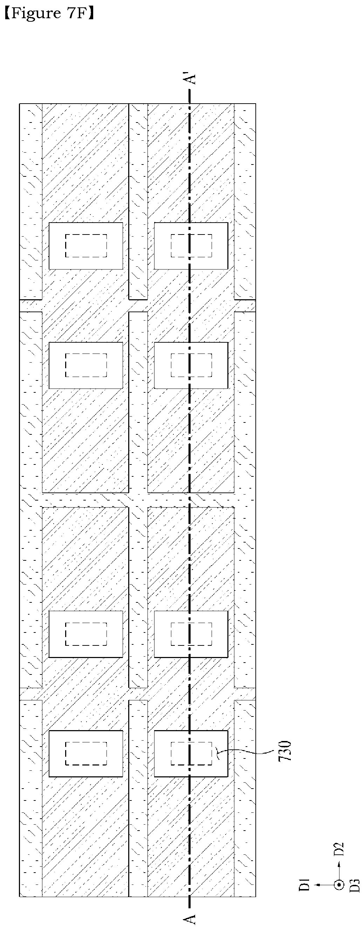

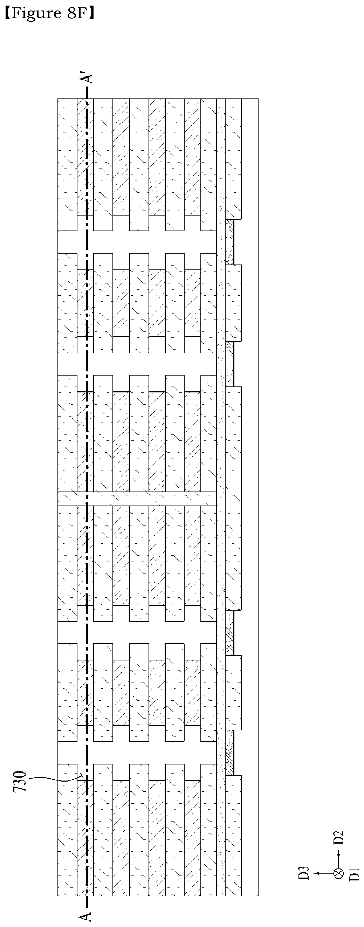

In step S630, the manufacturing system may recess each of the memory cell layers MEM in the horizontal direction (e.g., the first direction D1 and the second direction D2) via the transistor hole TH as shown in FIGS.7F and 8F. In more detail, the manufacturing system may determine a recess depth based on the thickness of the channel C made of the second semiconductor material in each of the recessed spaces 730 and the horizontal size of the cell isolated in each of the memory cell layers MEM, and then recess each of the memory cell layers MEM in the horizontal direction (e.g., the first direction D1 and the second direction D2) based on the determined depth. For example, the recess depth may be determined to be a value (e.g., 30nm) at which the counter doping layer CP, the second semiconductor material of the channel C, and the gate insulating film GD may be formed in the space 730 where each of the memory cell layers MEM was recessed under the condition of not leaving the inside of the cell in the semiconductor structure SEMI-STR.

In such recess step (S630), an ammonia solution or TMAH-based wet etching scheme may be used. In one example, recess step (S630) may be performed via a wet etching scheme under conditions in which the TMAH is diluted with IPA at a chemical temperature equal to or lower than 50°C and an etching rate is maintained at 20nm or lower for each minute.

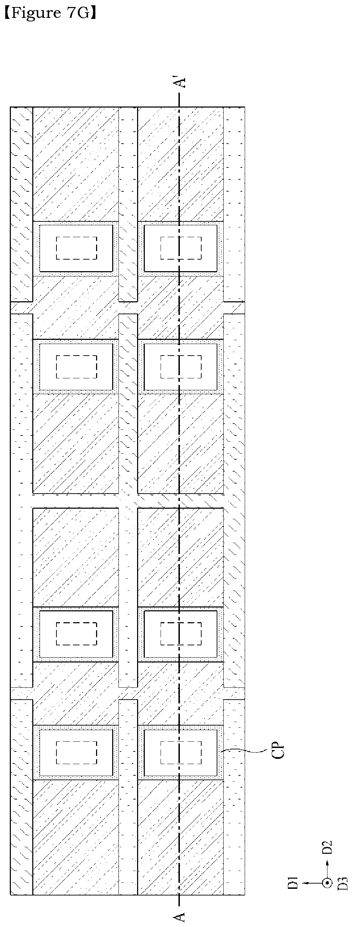

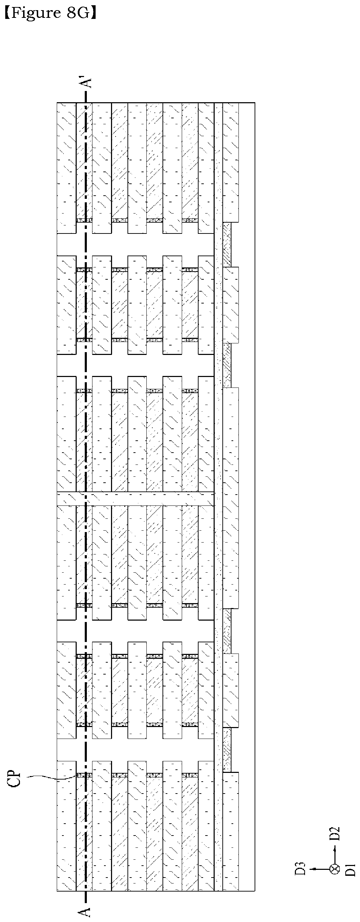

Moreover, in step S630, the manufacturing system may perform heat treatment on each of the recessed memory cell layers MEM such that the counter doping layer CP is formed in a portion where the first semiconductor material that forms the source SO and the drain DR of the transistor TR is in contact with the second semiconductor material that forms the channel C as shown in FIGS. 7G and 8G. For example, as $BH_3$ or $B_2H_6$ gas is used and thermal doping is performed at a temperature equal to or higher than 600°C, a surface of the first semiconductor material in contact with the second semiconductor material may be p-type substituted to form the counter doping layer CP. However, because the counter doping layer CP may be omitted, step S630 may be optionally performed or may not be performed.

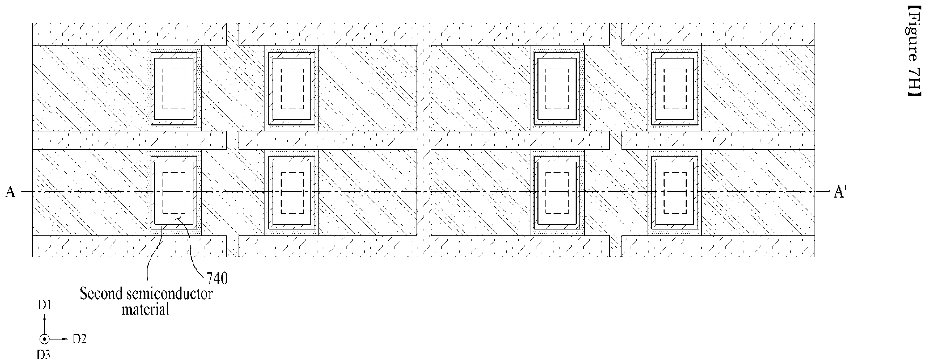

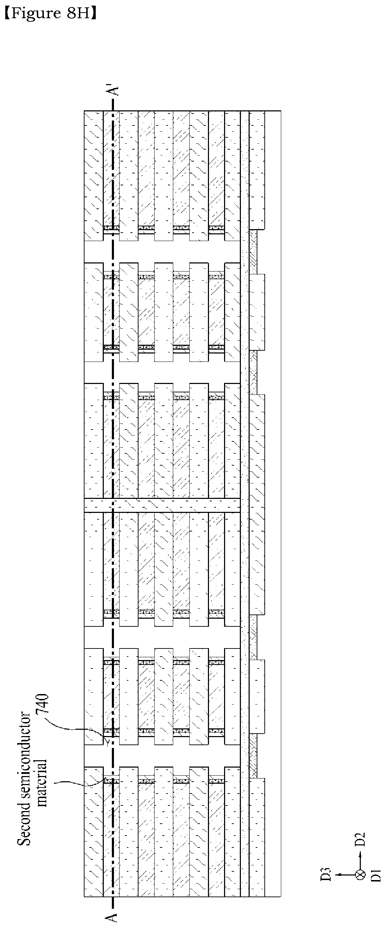

In step S640, the manufacturing system may selectively deposit the second semiconductor material in each of the recessed spaces 730 such that the channel C of the transistor TR is formed with the second semiconductor material such as silicon or silicon germanium with the low p-type impurity concentration to have the p-type high-resistance semiconductor characteristics as shown in FIGS. 7H and 8H. That is, in step S640, as the selective deposition and the etching of the second semiconductor material via the repeated ALD or CVD are repeated, the channel C may be formed in an intended portion by increasing selectivity. In this regard, in the selective deposition and the etching, $SiH_4$ or $Si_2H_6$ may be used for the selective deposition and $GeH_4$ may be used as source gas for germanium.

In this regard, for the channel C to be formed of the p-type, $BH_3$ or $B_2H_6$ gas may be used as doping gas. HCl may be used as gas to etch the second semiconductor material deposited in an undesired portion for the selective deposition.

Moreover, in step S640, the manufacturing system may perform heat treatment for stable crystallization of the counter doping layer CP, the source SO and the drain DR, and the channel C after the deposition of the second semiconductor material. The heat treatment may be performed at a temperature equal to or higher than 700°C to allow the doped impurities to diffuse. In particular, when depositing the second semiconductor material, as the concentration of the impurities is gradually reduced from an initial high concentration, the deposited second semiconductor material may have a uniform concentration.

In step S650, the manufacturing system may deposit the gate insulating film GD in each of spaces 740 where the second semiconductor material was selectively deposited.

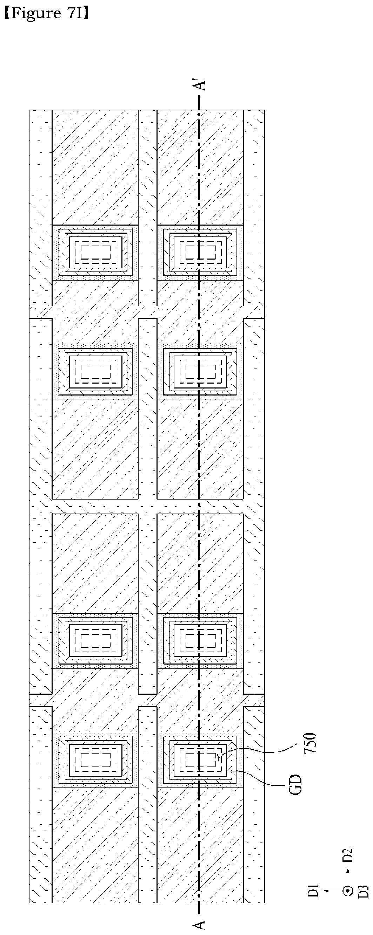

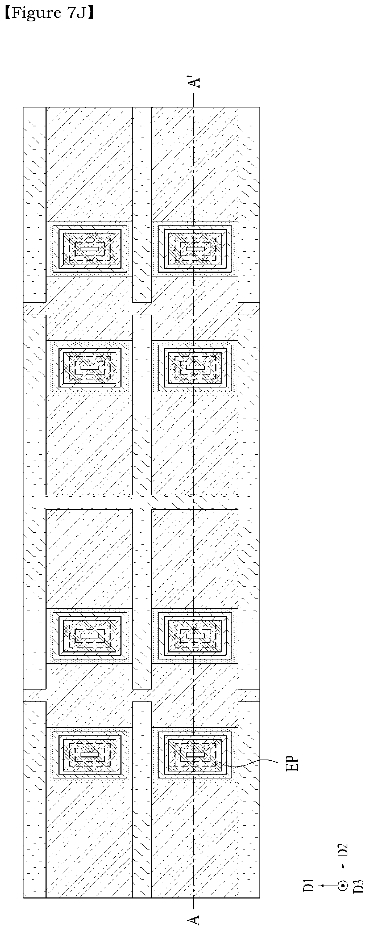

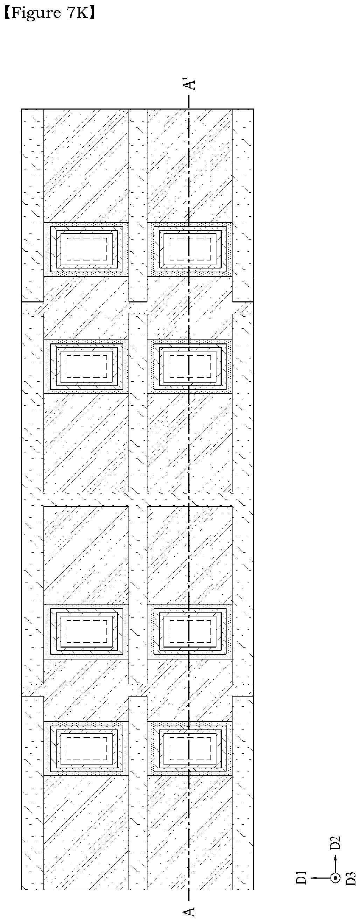

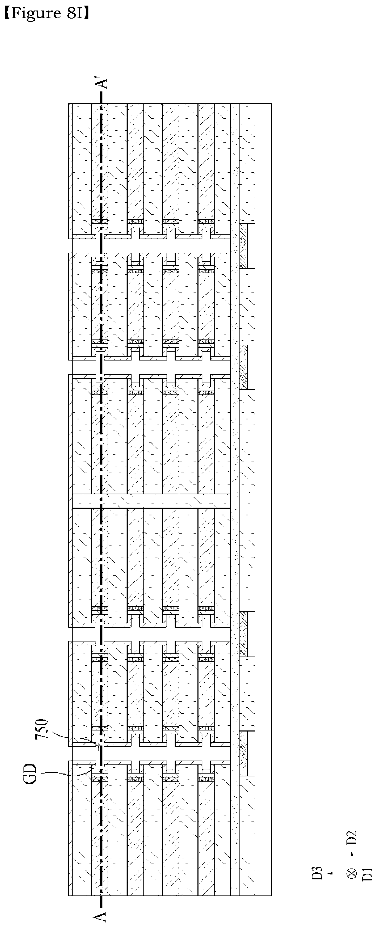

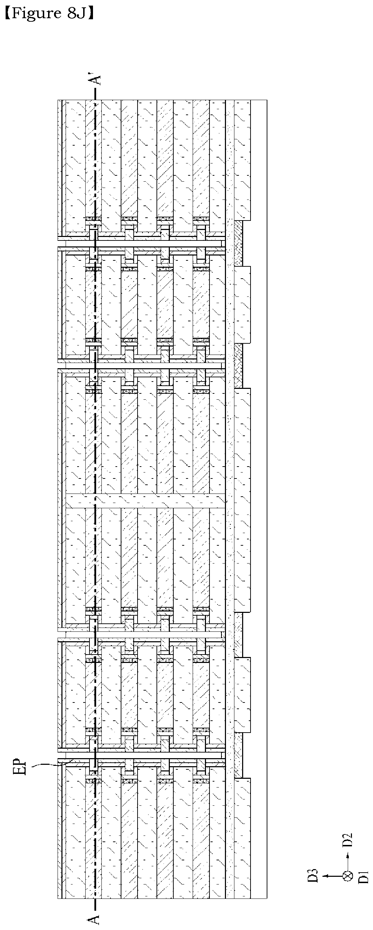

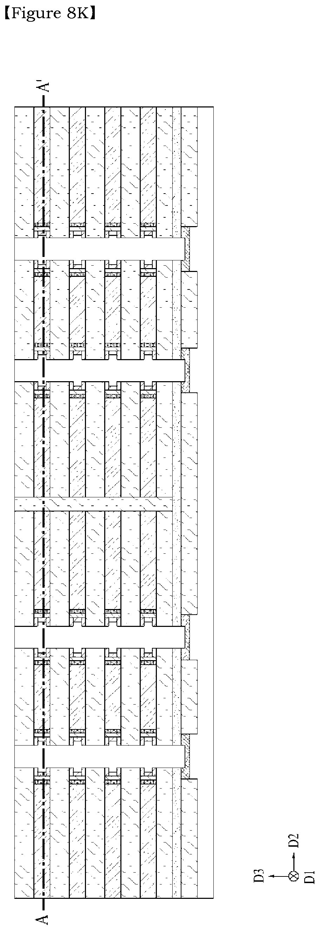

More specifically, in step S650, the manufacturing system may deposit the gate insulating film GD made of the insulating material that has the insulating properties like the dielectric (e.g., the high dielectric constant material (the high-k) such as the silicon oxide film, the silicon nitride film, the aluminum oxide film, and hafnium oxide) in each of the spaces 740 where the second semiconductor material was selectively deposited and the transistor hole TH as shown in FIGS. 7I and 8I, and deposit an etching protection film EP (the etching protection film EP prevents the gate insulating film GD from being etched in a process of removing the etching stopper ES included in the semiconductor structure SEMI-STR, which will be described later) made of polysilicon or the like in spaces 750 where the gate insulating film GD was deposited and the transistor hole TH as shown in FIGS. 7J and 8J. Thereafter, the manufacturing system may remove the etching protection film EP and the gate insulating film GD deposited in the transistor hole TH such that the gate insulating film GD remains only in each of the spaces 740 where the second semiconductor material was selectively deposited and may expose the gate connection channel GCC by removing the etching stopper ES in an etchback scheme as shown in FIGS. 7K and 8K. As a removal scheme, the ammonia solution or TMAH-based wet etching scheme may be used.

In step S660, the manufacturing system may form the gate film G in each of the spaces 750 where the gate insulating film GD was deposited and in the transistor hole TH as shown in FIGS. 7I and 8I. The gate film G may be made of the semiconductor material (e.g., polysilicon or the like) or the conductive material (e.g., tungsten (W), copper (Cu), aluminum (Al), titanium (Ti), tantalum (Ta), molybdenum (Mo), ruthenium (Ru), gold (Au), titanium nitride, tantalum nitride, and the like).

As such, the channel C, and the source SO and the drain DR in the transistor TR are respectively made of the second semiconductor material and the first semiconductor material doped with the different doping concentrations and the different types of impurities instead of being made of the same material and then formed via the doping process with the different doping concentrations as in the existing technology in the 2-dimensional DRAM, thereby making the impurity doping adjustment free and improving the performance of the transistor.

Moreover, although not shown in a separate plan view or cross-sectional view, in step S660, the manufacturing system may remove a portion of the gate film G deposited on top of the semiconductor structure SEMI-STR with CMP in the process in which the gate film G is deposited in each of the spaces 750 and the transistor hole TH such that the gate film G remains only within the transistor hole TH. When the gate film G remains only in the transistor hole TH, the manufacturing system may deposit an insulating film D on top of the semiconductor structure SEMI-STR, thereby completing the manufacturing process of the gate film G.

Moreover, although not shown as a separate step in FIG. 6, the manufacturing system may perform a selective deposition process of the bit line BL after step S660.

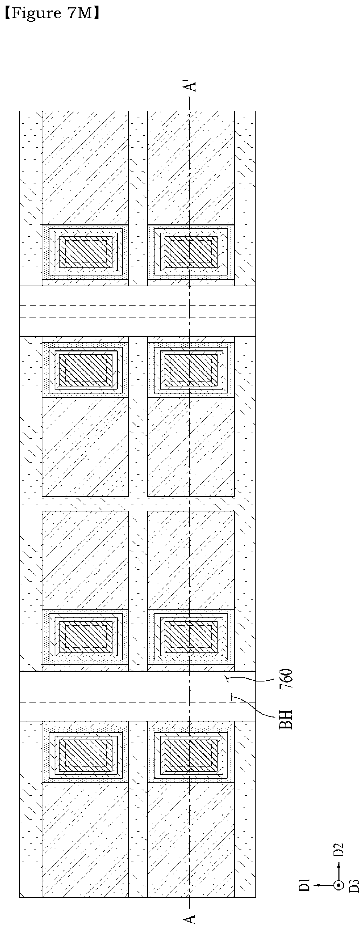

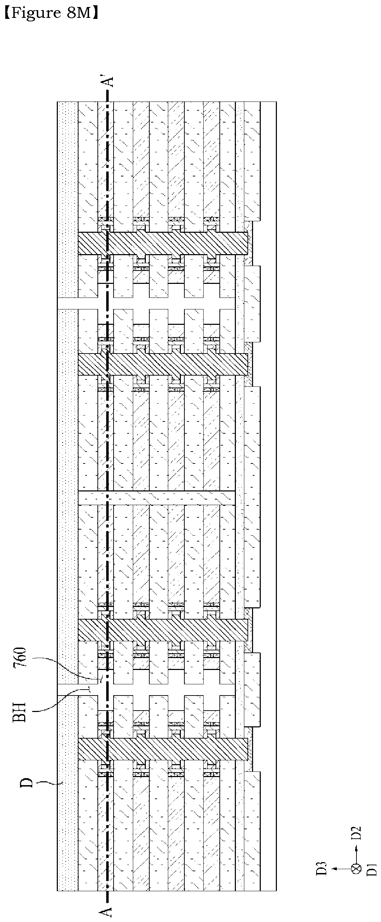

More specifically, the manufacturing system may etch a bit line hole BH in the vertical direction (e.g., the third direction D3) in an area between the isolated cells in the semiconductor structure SEMI-STR and perform recessing in the horizontal direction (e.g., the first direction D1 and the second direction D2) in each of the memory cell layers MEM via the bit line hole BH as shown in FIGS. 7M and 8M. The etching and recess process may use the ammonia water or TMAH-based wet etching scheme.

Hereinabove, the description has been made that the bit line hole BH is used to perform the recessing in the horizontal direction in each of the memory cell layers MEM, but the present disclosure may not be limited or restricted thereto and a bit line bar BB may be used.

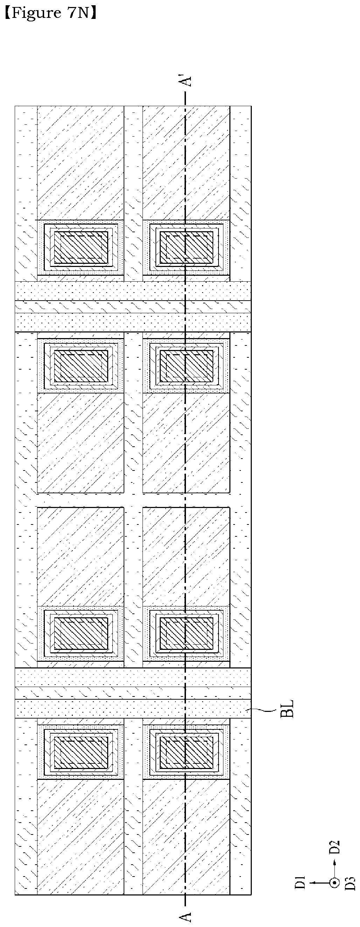

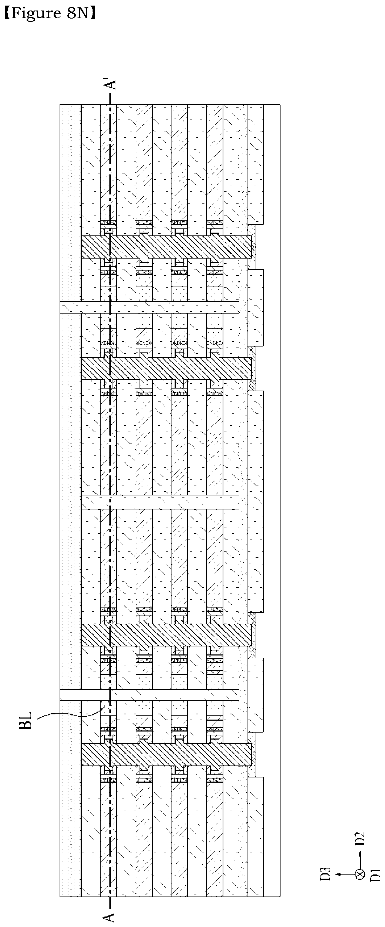

Thereafter, the manufacturing system may form the bit line BL with a semiconductor material (e.g., polysilicon and the like) or a conductive material (e.g., tungsten (W), copper (Cu), aluminum (Al), titanium (Ti), tantalum (Ta), molybdenum (Mo), ruthenium (Ru), gold (Au), titanium nitride, tantalum nitride, and the like) in recessed spaces 760 as shown in FIGS. 7N and 8N. For example, the manufacturing system may use WF6 as tungsten source gas, and use hydrogen in an initial deposition step and use SiH4 in a main deposition step as reactive gas. The reason for using hydrogen as the reaction gas in the initial deposition step is that selectivity between the first semiconductor material and the isolated insulating layer ILD is better when using the hydrogen reaction gas during the initial deposition than when using SiH4 and thus stable selective deposition characteristics are exhibited, and initial tungsten is able to be easily formed via a chemical reaction with the first semiconductor material to be deposited. Thereafter, tungsten is deposited while using SiH4 gas as the reaction gas to increase a deposition rate while maintaining selective properties, thereby completing the deposition. An appropriate deposition temperature is between 280°C and 350 °C, and as the deposition temperature decreases, the selective deposition characteristics may be improved.

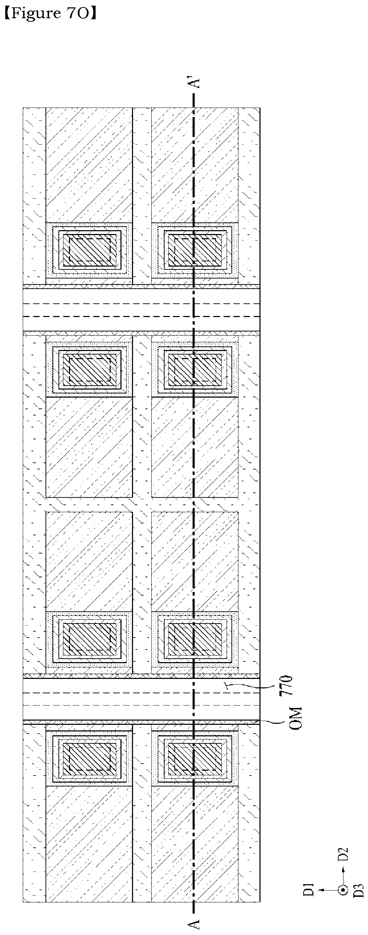

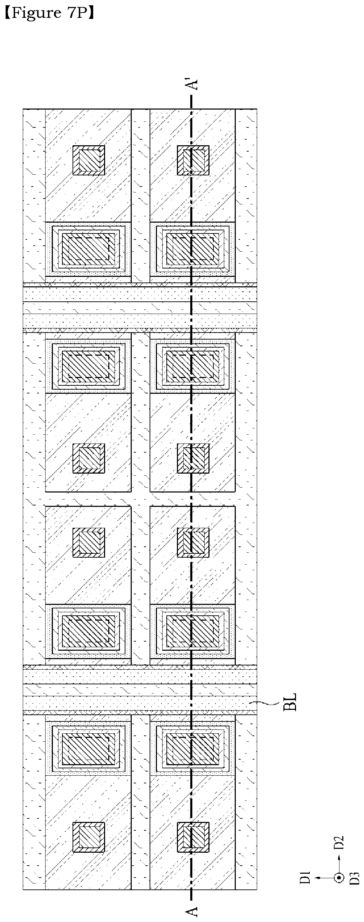

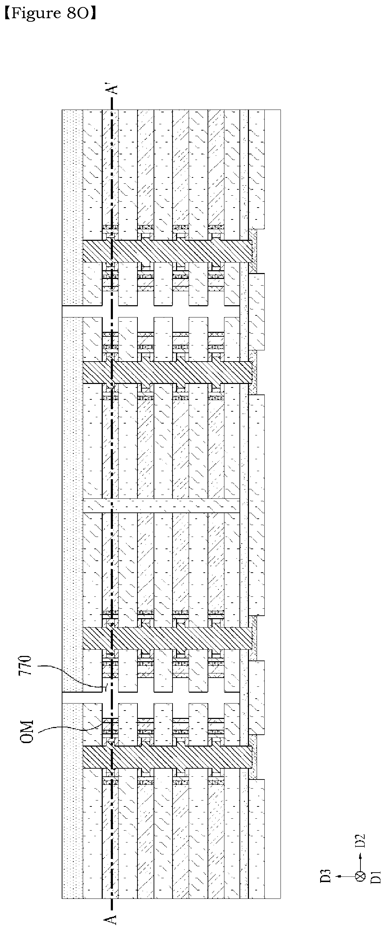

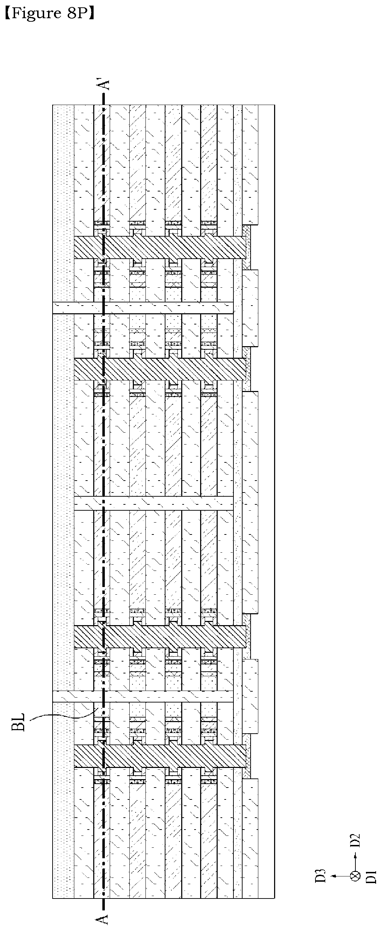

In this regard, the manufacturing system may first form the ohmic film OM before forming the bit line BL in the process of forming the bit line BL. For example, the manufacturing system may form the ohmic film OM to reduce a contact resistance with the first semiconductor material that forms the source SO and the drain DR of the transistor TR in each of the recessed spaces 760 as shown in FIGS. 7O and 8O, and then, form the bit line BL in spaces 770 where the ohmic film OM was formed as shown in FIGS. 7P and 8P.

The ohmic film OM may be made of the single metal including tungsten, molybdenum, cobalt, titanium, nickel, ruthenium, and the like or the metal silicide formed by the reaction of the single metal with silicon. For example, as the ohmic film OM, the ohmic silicide formed by the heat treatment of cobalt, nickel, or the like may be used. For a more specific example, the cobalt silicide formed by performing the primary heat treatment between 150°C and 250°C and then performing the secondary heat treatment between 500°C and 650°C on cobalt may be used as the ohmic film OM, and cobalt that did not react in the heat treatment may be removed via the wet etching using sulfuric acid, hydrogen peroxide, and the like.

After the bit line BL is formed, the manufacturing system may complete the manufacturing process of the transistor TR by filling the bit line hole BH (or the bit line bar BB) with an insulating film.

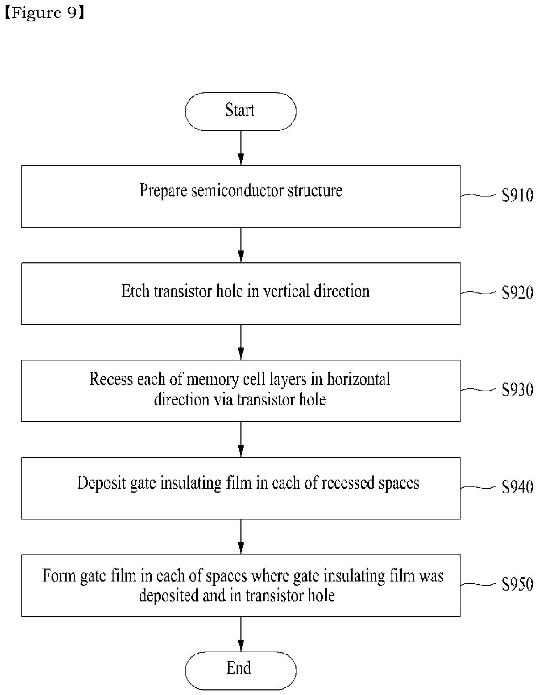

Hereinabove, although the method for manufacturing the transistor TR with the structure (the structure shown in FIG. 2A) in which the channel C surrounds the entirety of the gate film G on the plane (more precisely, the entirety of the gate insulating film GD) has been described, the transistor TR included in the 3-dimensional memory array according to an embodiment may have the structure (the structure shown in FIG. 2B) in which the channel C surrounds the portion of the gate film G on the plane (e.g., the upper and lower portions of the gate film G on the plane) (more precisely, the upper and lower portions of the gate insulating film GD on the plane). A method for manufacturing the same will be described with reference to FIGS. 9 to 11 below.

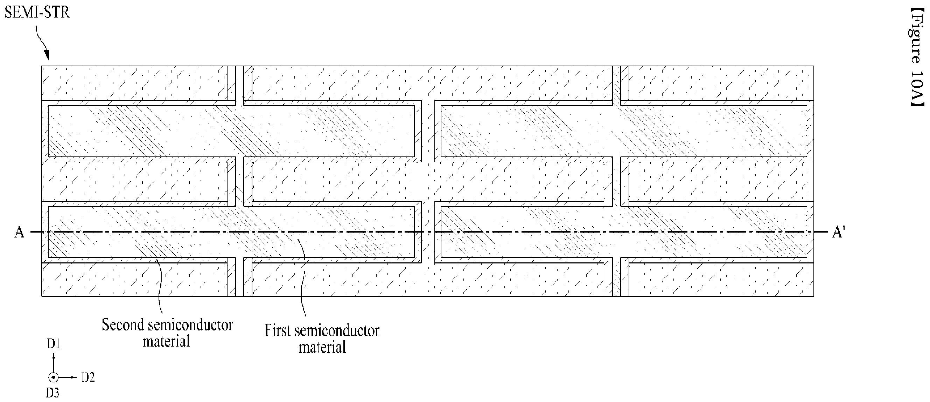

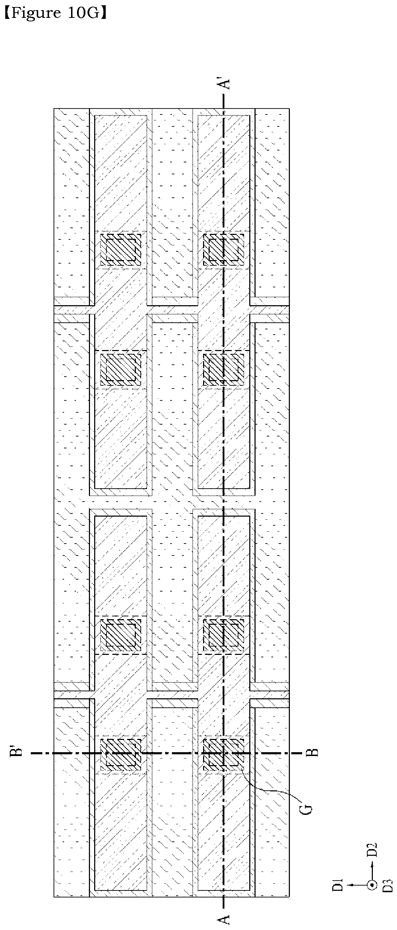

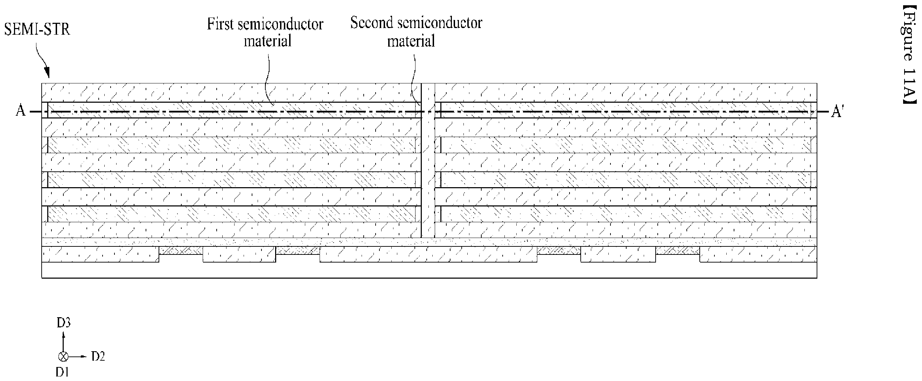

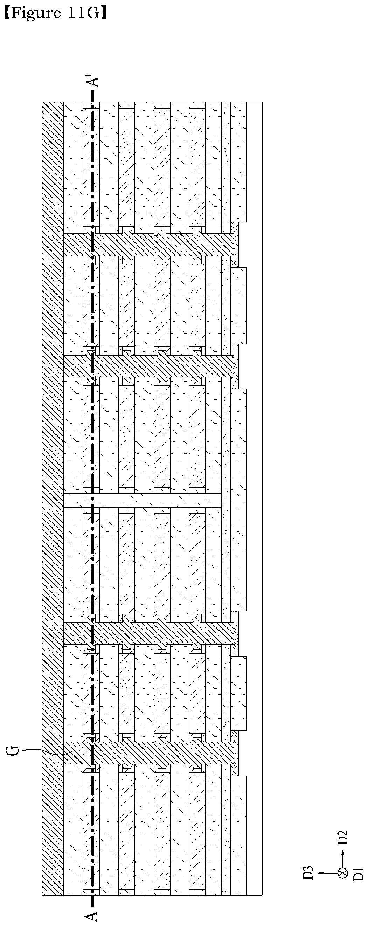

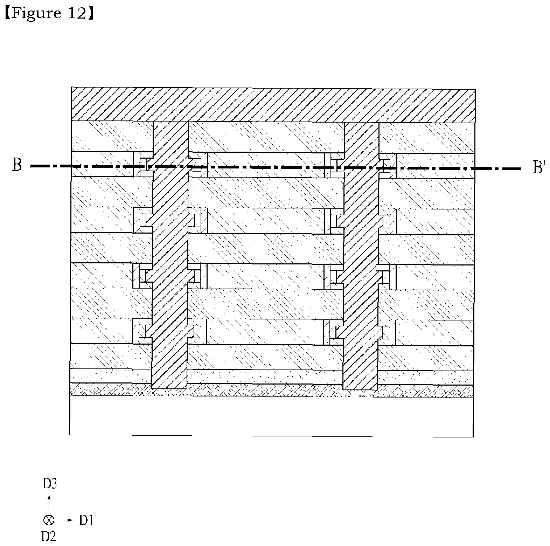

FIG. 9 is a flowchart showing a method for manufacturing a transistor in a 3-dimensional memory array according to another embodiment, FIGS. 10A to 10G are plan views showing a 3-dimensional memory array to illustrate a method for manufacturing a transistor in a 3-dimensional memory shown in FIG. 9, FIGS. 11A to 11G are cross-sectional views showing a 3-dimensional memory array to illustrate a method for manufacturing a transistor in a 3-dimensional memory shown in FIG. 9 and correspond to cross-sections of FIGS. 10A to 10G taken along a line A-A', and FIG. 12 is a cross-sectional view of a 3-dimensional memory array shown in FIG. 10G taken along a line B-B'. The method for manufacturing the transistor in the 3-dimensional memory array to be described below is for manufacturing the transistor with the structure in which the channel C surrounds the portion of the gate film G on the plane rather than the entirety of the gate film G and is assumed to be performed by the automated and mechanized manufacturing system.

Referring to FIG. 9, in step S910, the manufacturing system may prepare the semiconductor structure SEMI-STR including the isolated insulating layers ILD and the memory cell layers MEM stacked alternately in the vertical direction and the gate connection channels GCC, with the cells isolated by the second semiconductor material deposited on an etched side surface of each of the memory cell layers MEM, as shown in FIGS. 10A and 11A.

In this regard, each of the memory cell layers MEM may be made of the first semiconductor material such as silicon or silicon germanium with the high n-type impurity concentration to have the n-type low-resistance semiconductor characteristics, and each of the isolated insulating layers ILD may be made of the insulating material (e.g., the low-k) such as the silicon oxide film or the silicon nitride film.

More specifically, in step S910, the manufacturing system may prepare the substrate SUB including the gate connection channel GCC and in which the isolated insulating layers ILD and the memory cell layers MEM are alternatively deposited and stacked using the CVD scheme or the like. Subsequently, the manufacturing system may etch remaining portions leaving a cell portion in the semiconductor structure SEMI-STR to isolate the cell in each of the memory cell layers MEM, and etch, in the horizontal direction, a portion of each of the memory cell layers MEM in the side surface where the remaining portions were etched. Accordingly, the manufacturing system may prepare the semiconductor structure SEMI-STR as shown in FIGS. 10A and 11A by depositing the second semiconductor material such as silicon or silicon germanium with the low p-type impurity concentration to have the p-type high-resistance semiconductor characteristics on the side surface where the portion of each of the memory cell layers MEM was etched. The deposition of the second semiconductor material may be performed in the intended portion by increasing the selectivity by repeating the selective deposition and etching via the repeated ALD or CVD. For the selective deposition, $SiH_4$ or $Si_2H_6$ may be used, and $GeH_4$ may be used as the source gas for germanium. In this regard, for the second semiconductor material to be formed of the p-type, $BH_3$ or $B_2H_6$ gas may be used as the doping gas. HCl may be used as the gas to etch the second semiconductor material deposited in the undesired portion for the selective deposition.

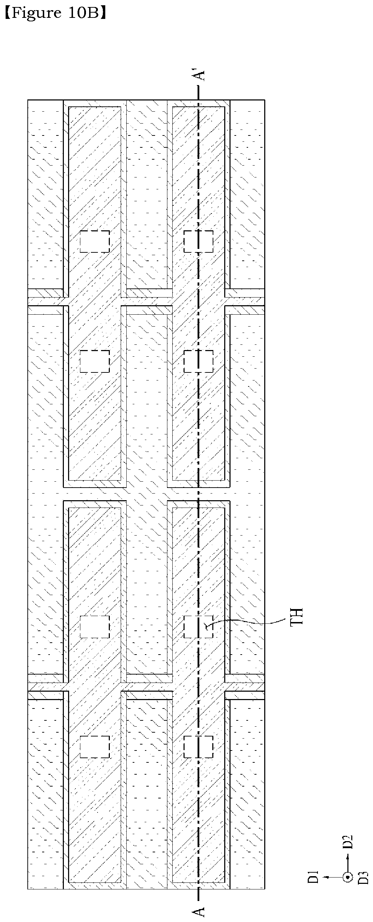

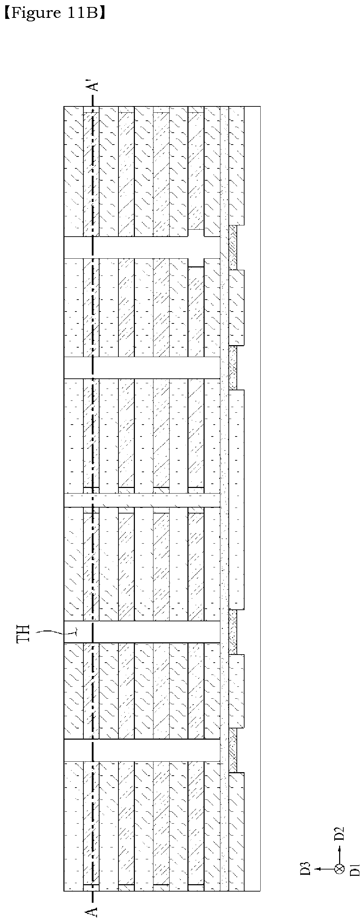

In step S920, the manufacturing system may etch the transistor hole TH in the vertical direction (e.g., the D3) in the semiconductor structure SEMI-STR, as shown in FIGS. 10B and 11B. Hereinafter, the transistor hole TH refers to the contact hole in which the gate film G is formed.

When the transistor hole TH is etched, the horizontal etching size in the second direction D2 among the horizontal directions is important. The horizontal etching size of the transistor hole TH may be determined to be a size that allows the gate insulating film GD to be formed in recessed spaces 1010 under a condition of not exceeding a horizontal size of the cell isolated in the semiconductor structure SEMI-STR.

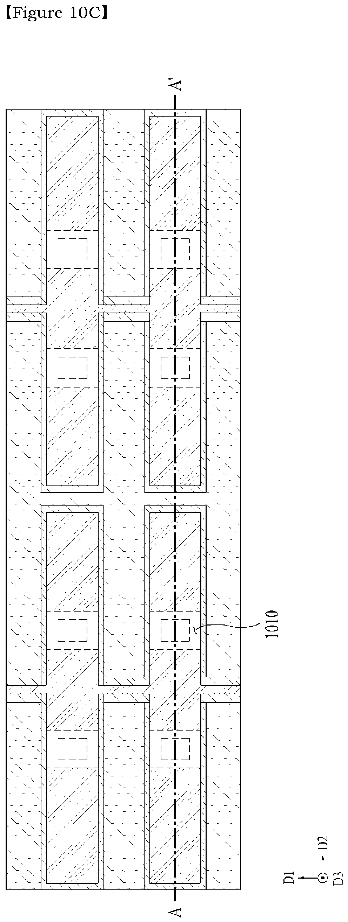

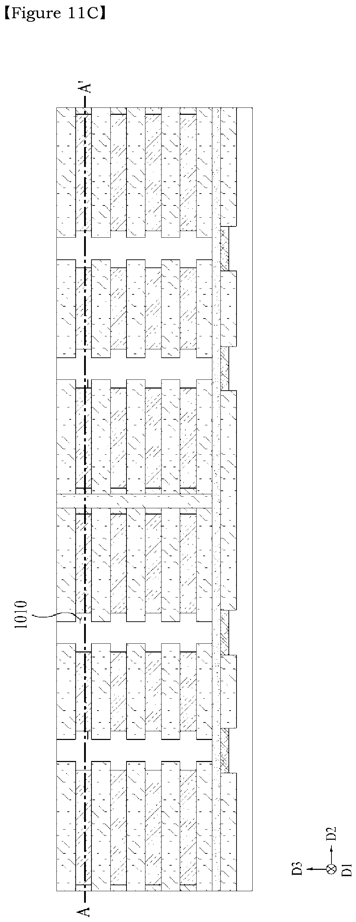

In step S930, the manufacturing system may recess each of the memory cell layers MEM in the horizontal direction (e.g., the first direction D1 and the second direction D2) via the transistor hole TH as shown in FIGS. 10C and 11C. In more detail, the manufacturing system may determine a recess depth such that the second semiconductor material is exposed in each of the recessed spaces 1010 based on the horizontal size of the isolated cell in each of the memory cell layers MEM, and then recess each of the memory cell layers MEM in the horizontal direction based on the determined depth. For example, the recess depth may be determined to be a value (a value in a range from 5nm to 10nm because the thickness of the gate insulating film GD is usually around 4nm) at which the gate insulating film GD may be formed via the space 1010 where each of the memory cell layers MEM was recessed under a condition of not leaving the inside of the cell in the semiconductor structure SEMI-STR.

In such recess step (S930), the ammonia solution or TMAH-based wet etching scheme may be used. In one example, recess step (S930) may be performed via the wet etching scheme under the conditions in which the TMAH is diluted with the IPA at the chemical temperature equal to or lower than 50°C and the etching rate is maintained at 20nm or lower for each minute.

Moreover, although not shown in separate plan view and cross-sectional view, in step S930, the manufacturing system may perform the heat treatment on each of the recessed memory cell layers MEM such that the counter doping layer CP is formed in the portion where the first semiconductor material that forms the source SO and the drain DR of the transistor TR is in contact with the second semiconductor material that forms the channel C. A detailed description thereof has been made above, and thus, will be omitted.

Moreover, in step S930, the manufacturing system may perform the heat treatment for the stable crystallization of the counter doping layer CP, the source SO and the drain DR, and the channel C. The heat treatment may be performed at the temperature equal to or higher than 700°C to allow the doped impurities to diffuse.

In step S940, the manufacturing system may deposit the gate insulating film GD in each of the recessed spaces 1010.

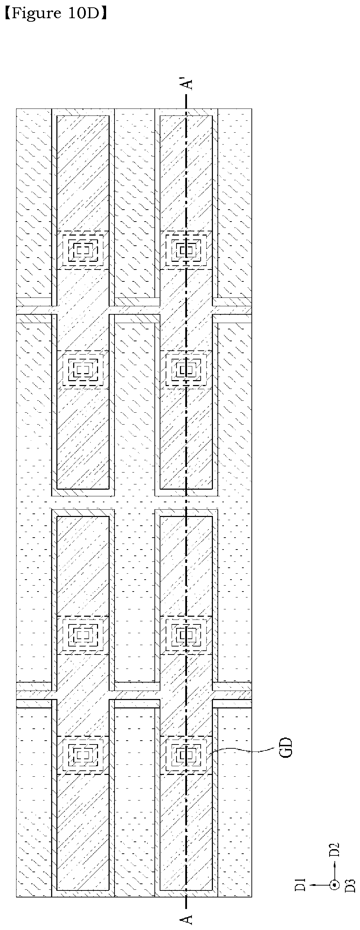

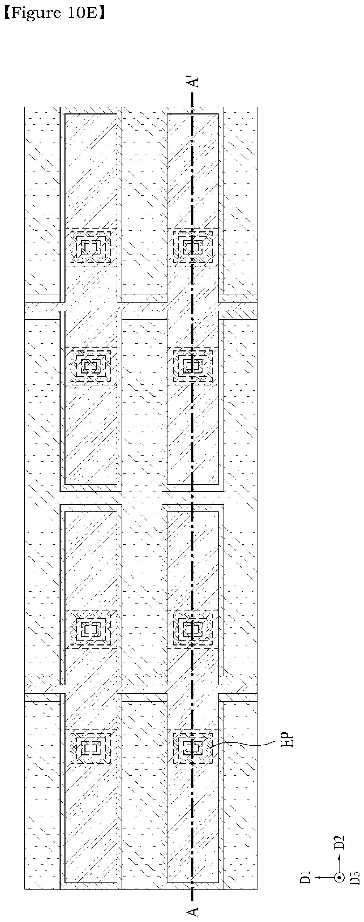

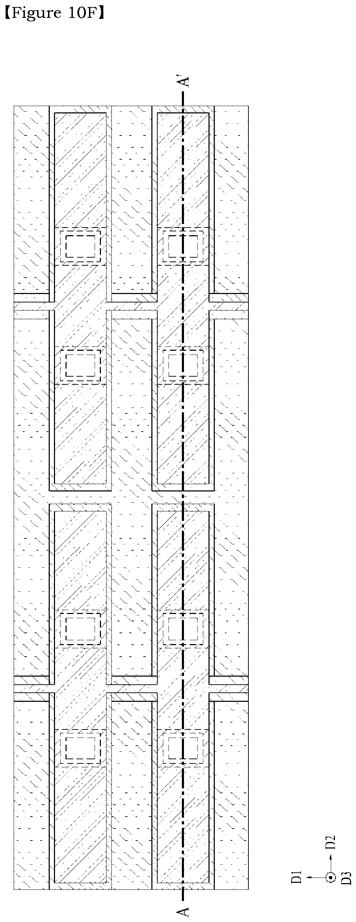

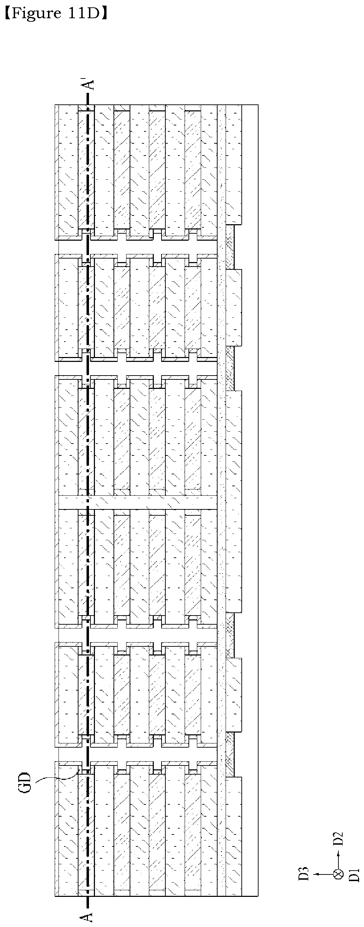

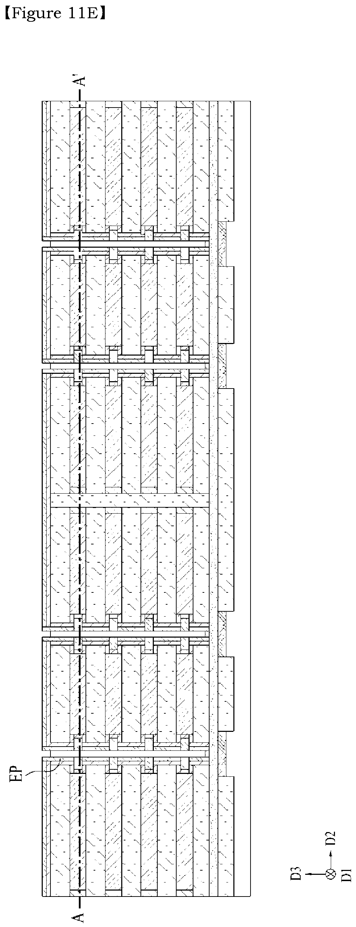

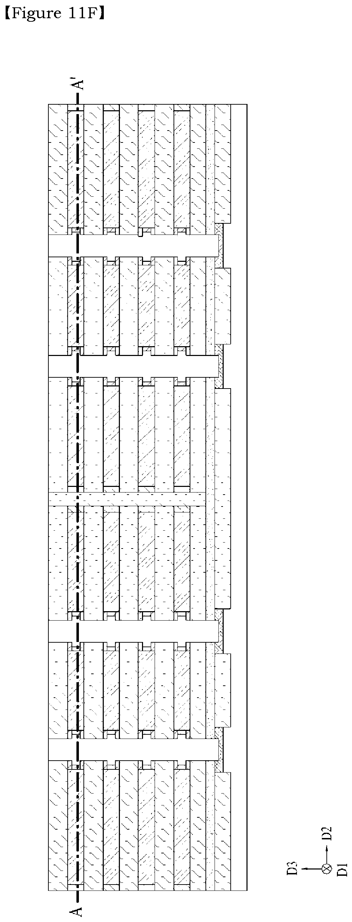

More specifically, in step S940, the manufacturing system may deposit the gate insulating film GD made of the insulating material that has the insulating properties like the dielectric (e.g., the high dielectric constant material (the high-k) such as the silicon oxide film, the silicon nitride film, the aluminum oxide film, and hafnium oxide) in each of the recessed spaces 1010 and the transistor hole TH as shown in FIGS. 10D and 11D, and deposit the etching protection film EP (the etching protection film EP prevents the gate insulating film GD from being etched in the process of removing the etching stopper ES included in the semiconductor structure SEMI-STR, which will be described later) made of polysilicon or the like in the recessed spaces 1010 and the transistor hole TH as shown in FIGS. 10E and 11E. Thereafter, the manufacturing system may remove the etching protection film EP and the gate insulating film GD deposited in the transistor hole TH such that the gate insulating film GD remains only in each of the recessed spaces 1010 and may expose the gate connection channel GCC by removing the etching stopper ES in the etchback scheme as shown in FIGS. 10F and 11F. As the removal scheme, the ammonia solution or TMAH-based wet etching scheme may be used.

In step S950, the manufacturing system may form the gate film G in each of spaces 1020 where the gate insulating film GD was deposited and in the transistor hole TH as shown in FIGS. 10G, 11G, and 12. The gate film G may be made of the semiconductor material (e.g., polysilicon or the like) or the conductive material (e.g., tungsten (W), copper (Cu), aluminum (Al), titanium (Ti), tantalum (Ta), molybdenum (Mo), ruthenium (Ru), gold (Au), titanium nitride, tantalum nitride, and the like).

As such, the channel C, and the source SO and the drain DR in the transistor TR are respectively made of the second semiconductor material and the first semiconductor material doped with the different doping concentrations and the different types of impurities instead of being made of the same material and then formed via the doping process with the different doping concentrations as in the existing technology in the 2-dimensional DRAM, thereby making the impurity doping adjustment free and improving the performance of the transistor.

Moreover, although not shown in a separate plan view or cross-sectional view, in step S950, the manufacturing system may remove the portion of the gate film G deposited on top of the semiconductor structure SEMI-STR with the CMP in the process in which the gate film G is deposited in each of the spaces 1020 and the transistor hole TH such that the gate film G remains only within the transistor hole TH. When the gate film G remains only in the transistor hole TH, the manufacturing system may deposit the insulating film on top of the semiconductor structure SEMI-STR, thereby completing the manufacturing process of the gate film G.

Because the selective deposition process of the bit line BL to be performed subsequently is the same as described above, a description thereof will be omitted.

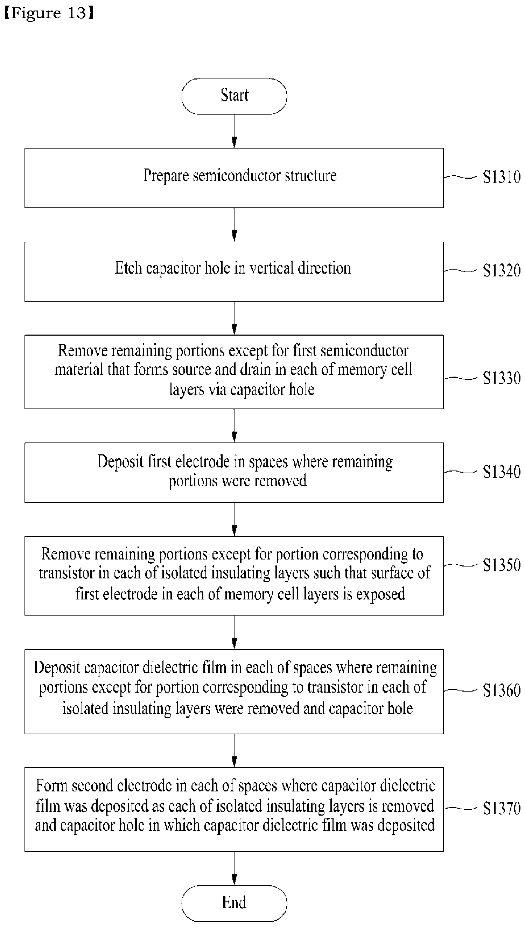

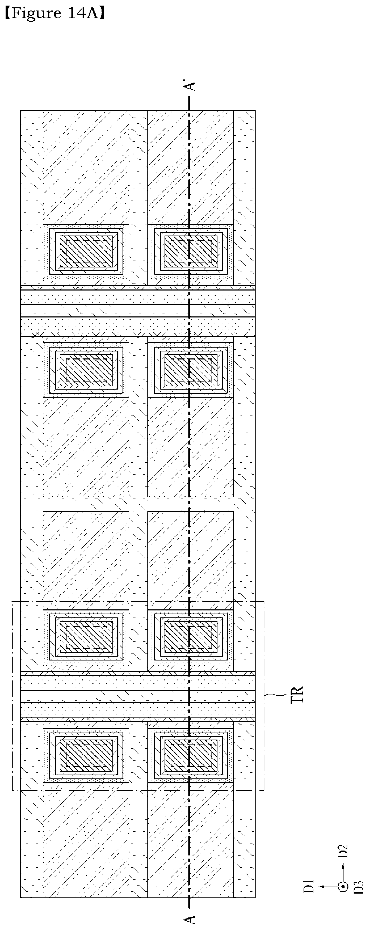

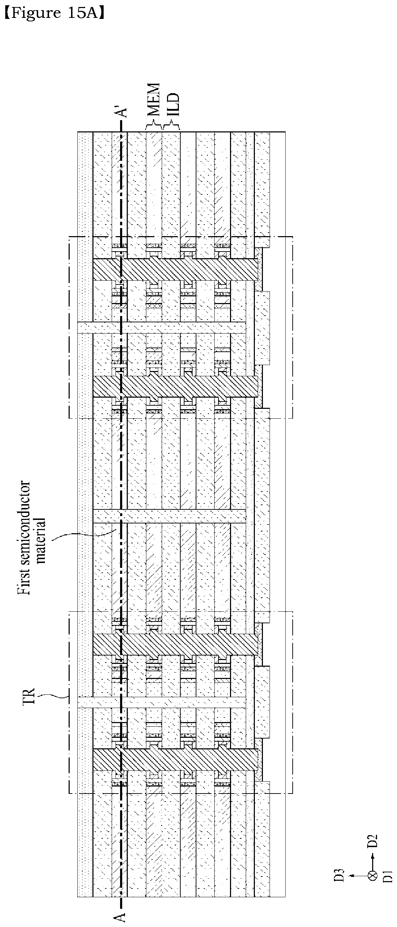

FIG. 13 is a flowchart showing a method for manufacturing a capacitor in a 3-dimensional memory array according to an embodiment, FIGS. 14A to 14L are plan views showing a 3-dimensional memory array to illustrate a method for manufacturing a capacitor in a 3-dimensional memory array shown in FIG. 13, and FIGS. 15A to 15L are cross-sectional views showing a 3-dimensional memory array to illustrate a method for manufacturing a capacitor in a 3-dimensional memory array shown in FIG. 13 and correspond to cross-sections of FIGS. 14a to 14L taken along a line A-A'. The method for manufacturing the capacitor in the 3-dimensional memory array to be described below is for manufacturing the capacitor CAP included in the 3-dimensional memory array with the structure described with reference to FIGS. 1 to 5 and is assumed to be performed by the automated and mechanized manufacturing system. Moreover, hereinafter, the method for manufacturing the capacitor CAP in the semiconductor structure SEMI-STR after the above-described transistor manufacturing method is performed will be described, but the present disclosure is not limited or restricted thereto.

Referring to FIG. 13, in step S1310, the manufacturing system may prepare the semiconductor structure SEMI-STR including the isolated insulating layers ILD and the memory cell layers MEM stacked alternately in the vertical direction (e.g., the third direction D3) and the gate connection channels GCC, with the cells isolated in each of the memory cell layers MEM, as shown in FIGS. 14A and 15A.

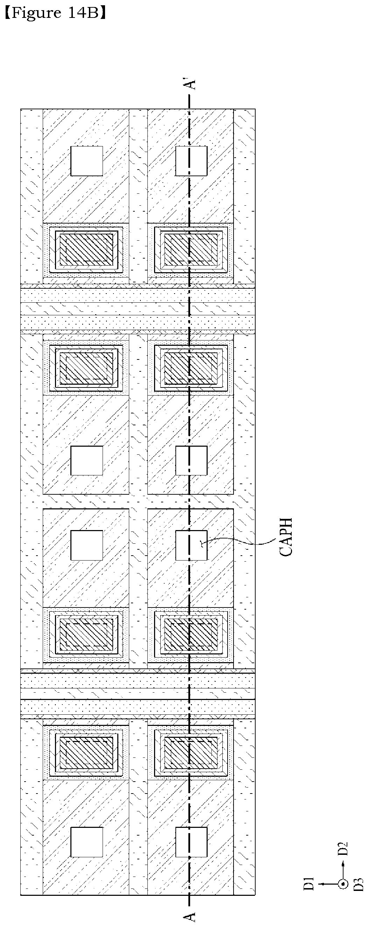

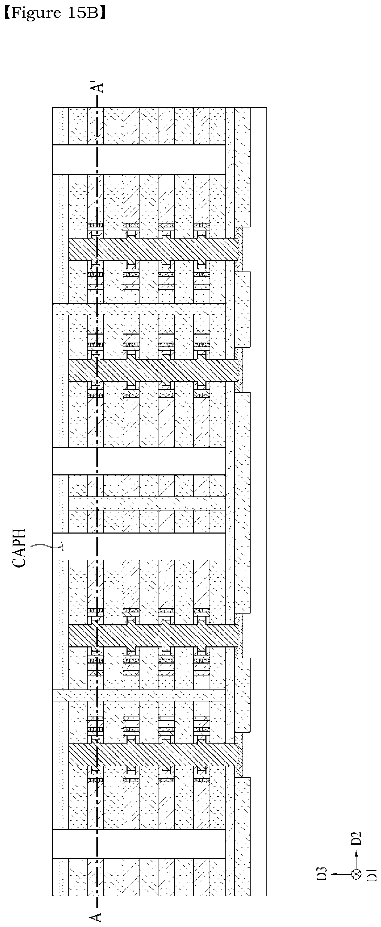

In step S1320, the manufacturing system may etch a capacitor hole CAPH in the semiconductor structure SEMI-STR in the vertical direction (e.g., the third direction D3) as shown in FIGS. 14B and 15B. Hereinafter, the capacitor hole CAPH refers to a contact hole in which the second electrode EL2 is formed.

As shown in the drawing, the capacitor hole CAPH may be etched at a location where a length L1 from the capacitor hole CAPH to an end of the cell is smaller than a length L2 from the capacitor hole CAPH to the source SO. This is for the wet etching to be performed up to the end of the cell and for the source SO to remain when the first semiconductor material is removed. That is, the capacitor hole CAPH may be etched in the vertical direction at any location on the semiconductor structure SEMI-STR considering a thickness of the source SO included in the transistor TR.

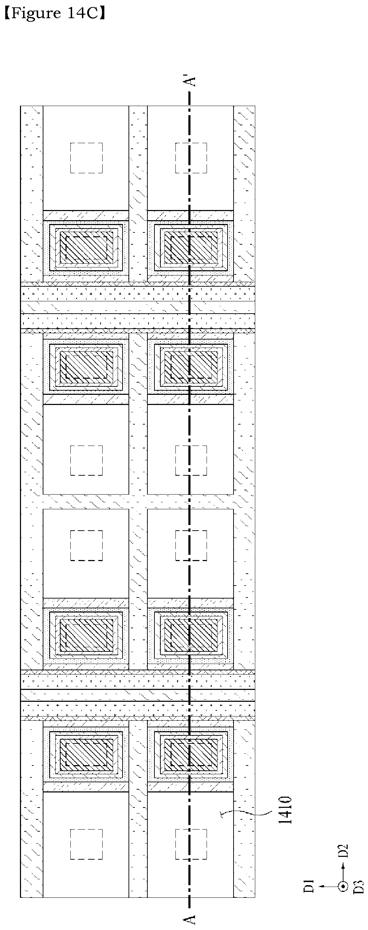

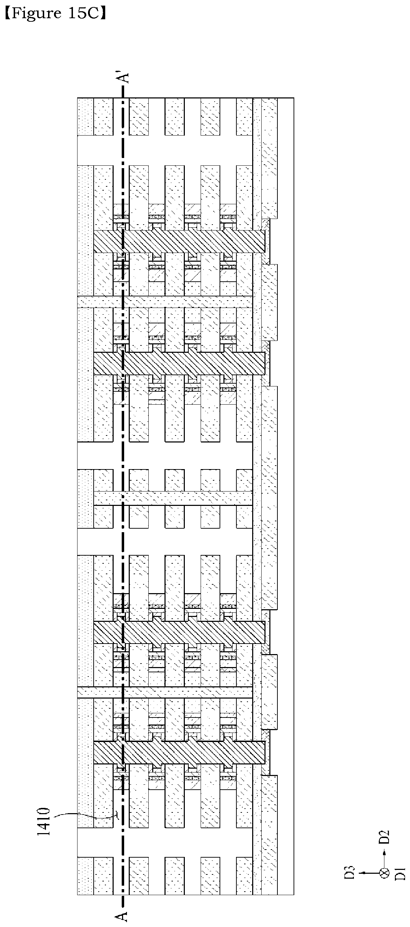

In step S1330, the manufacturing system may remove remaining portions except for the first semiconductor material that forms the source SO and the drain DR of the transistor TR manufactured in the semiconductor structure SEMI-STR in each of the memory cell layers MEM via the capacitor hole CAPH as shown in FIGS. 14C and 15C. As a removal scheme, the ammonia solution or TMAH-based wet etching scheme may be used. In one example, step S1330 may be performed via the wet etching scheme under the conditions in which the TMAH is diluted with the IPA at the chemical temperature equal to or lower than 50°C and the etching rate is maintained at 20nm or lower for each minute.

In step S1340, the manufacturing system may deposit the first electrode EL1 in spaces 1410 where the remaining portions were removed. More specifically, the manufacturing system may deposit the first electrode EL1 in the spaces 1410 where the remaining portions were removed and the capacitor hole CAPH and then remove the first electrode EL1 deposited in the capacitor hole CAPH, so that the first electrode EL1 may remain only in the spaces 1410 where the remaining portion were removed. This will be described along with formation of the ohmic film OM below.

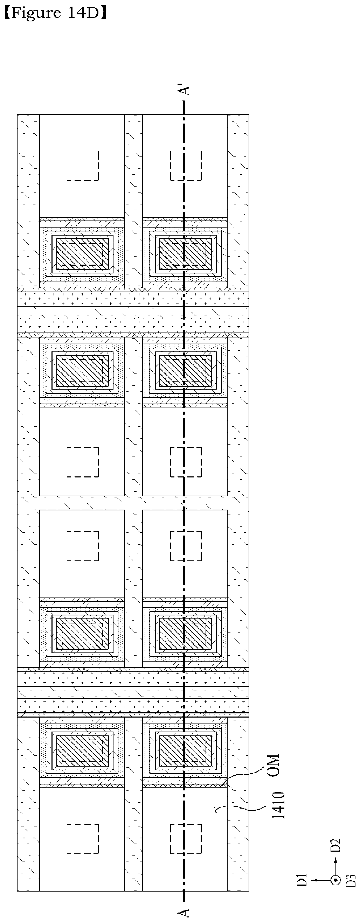

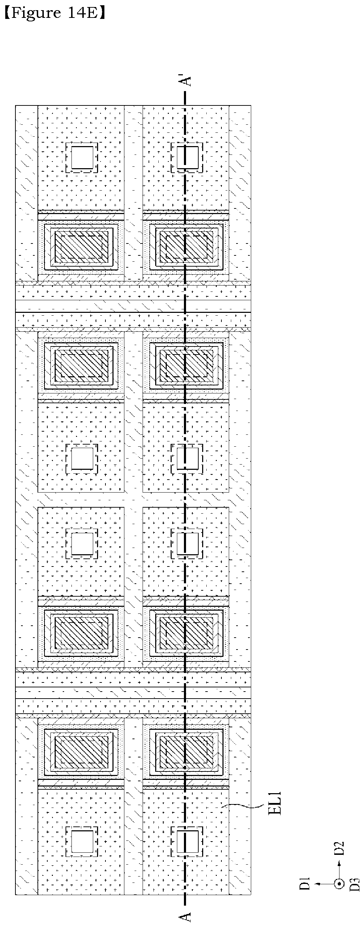

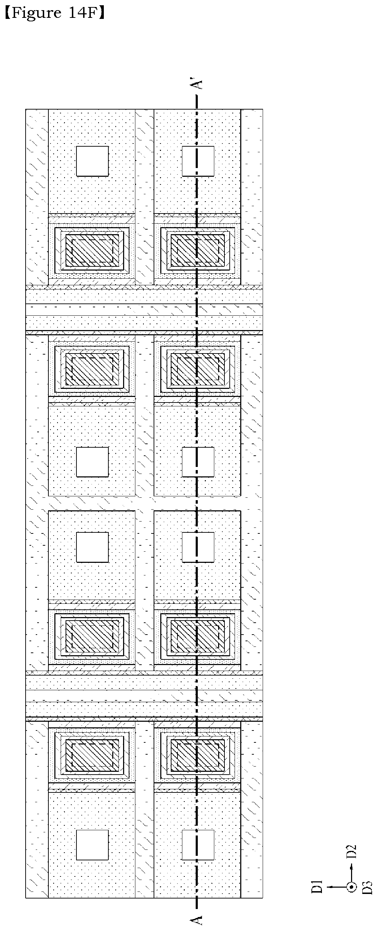

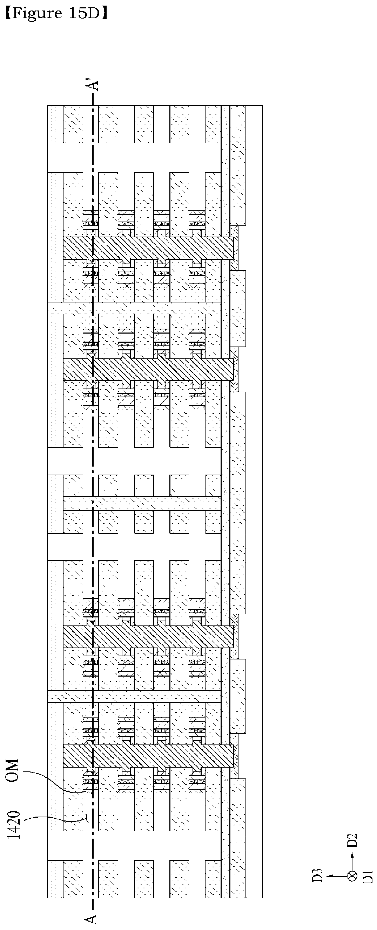

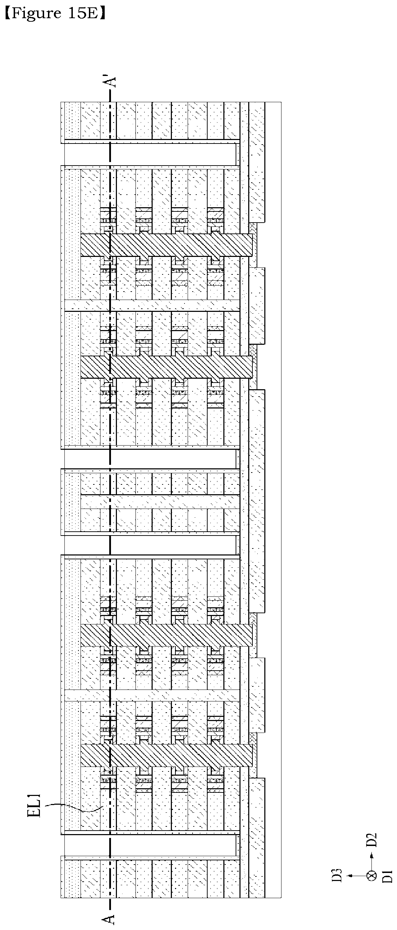

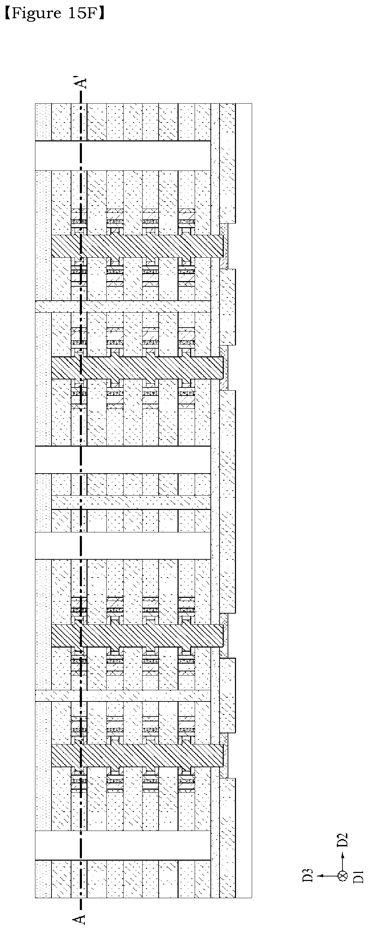

In this regard, the manufacturing system may first form the ohmic film OM before forming the first electrode EL1 in the process of depositing the first electrode EL1. For example, the manufacturing system may form the ohmic film OM to reduce the contact resistance with the first semiconductor material that forms the source SO and the drain DR of the transistor TR in each of the spaces 1410 where the remaining portion were removed as shown in FIGS. 14D and 15D, and then, the first electrode EL1 may be deposited in spaces 1420 where the ohmic film OM was formed and the capacitor hole CAPH as shown in FIGS. 14E and 15E. Subsequently, the manufacturing system may remove the first electrode EL1 deposited in the capacitor hole CAPH as shown in FIGS. 14F and 15F, so that the first electrode EL1 may remain only in the spaces 1420 where the ohmic film OM was formed.

The ohmic film OM may be made of the single metal including tungsten, molybdenum, cobalt, titanium, nickel, ruthenium, and the like or the metal silicide formed by the reaction of the single metal with silicon. For example, as the ohmic film OM, the ohmic silicide formed by the heat treatment of cobalt, nickel, or the like may be used. For a more specific example, the cobalt silicide formed by performing the primary heat treatment between 150°C and 250°C and then performing the secondary heat treatment between 500°C and 650°C on cobalt may be used as the ohmic film OM, and cobalt that did not react in the heat treatment may be removed via the wet etching using sulfuric acid, hydrogen peroxide, and the like.

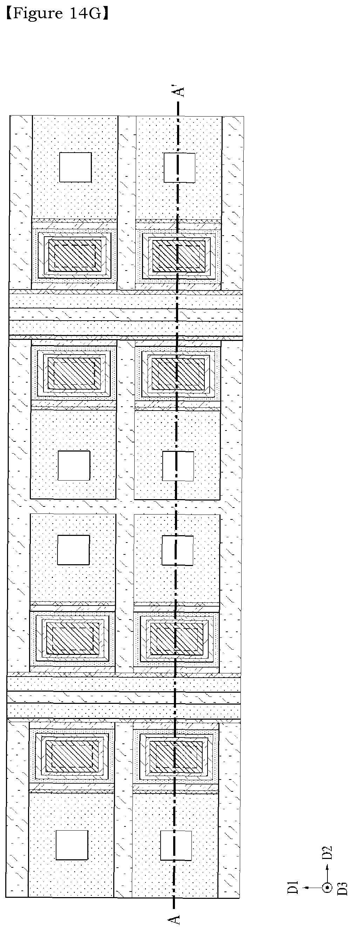

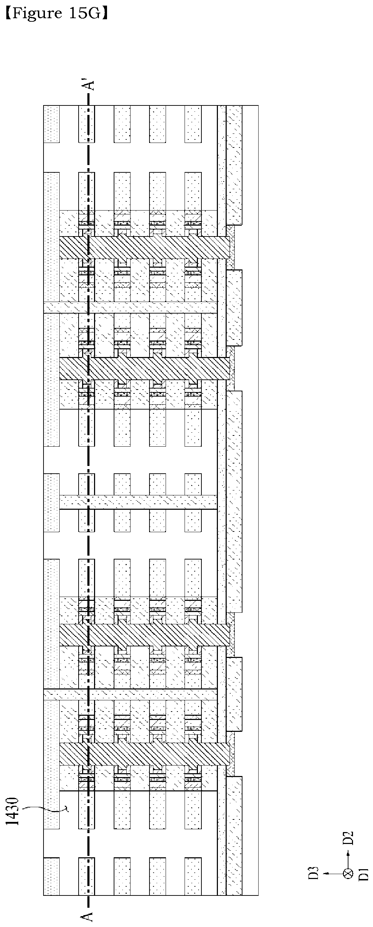

In step S1350, the manufacturing system may remove remaining portions except for a portion corresponding to the transistor TR in each of the isolated insulating layers ILD such that a surface of the first electrode EL1 formed in each of the memory cell layers MEM is exposed as shown in FIGS. 14G and 15G, so that one of the side surfaces, the top surface, and the bottom surface of the first electrode EL1 may be exposed. For example, the manufacturing system may perform the wet etching on the remaining portions at a level at which the ohmic film OM in contact with the first electrode EL1 and the source SO or the source SO is not exposed. Accordingly, leakage current characteristics may be prevented from being deteriorated as the ohmic film OM or the source SO is exposed.

In the process of removing the remaining portions except for the portion corresponding to the transistor TR in each of the isolated insulating layers ILD, the wet etching scheme described above may be used.

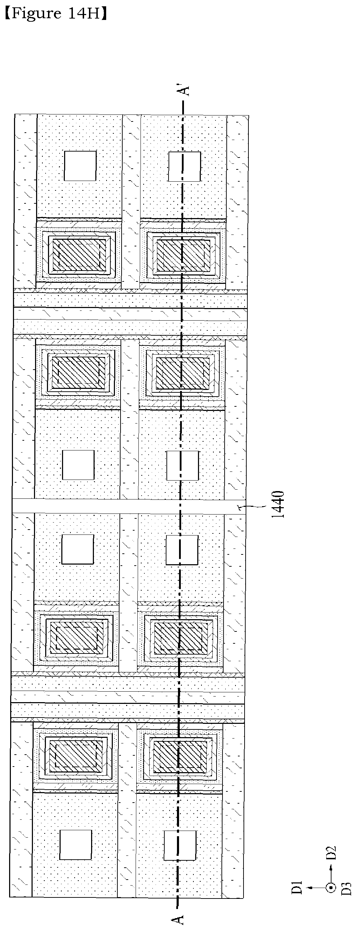

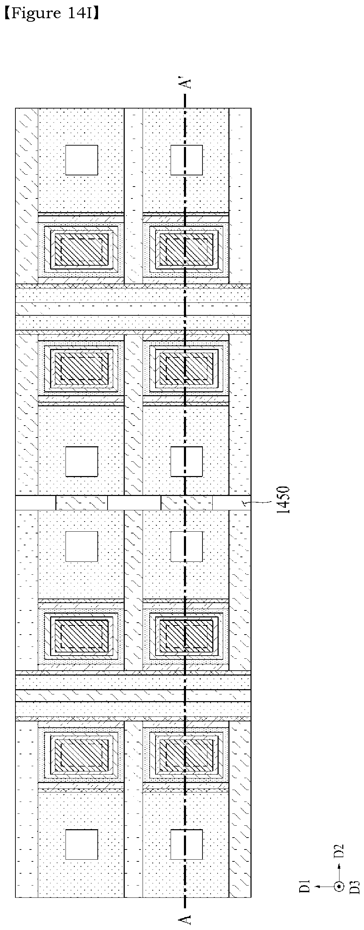

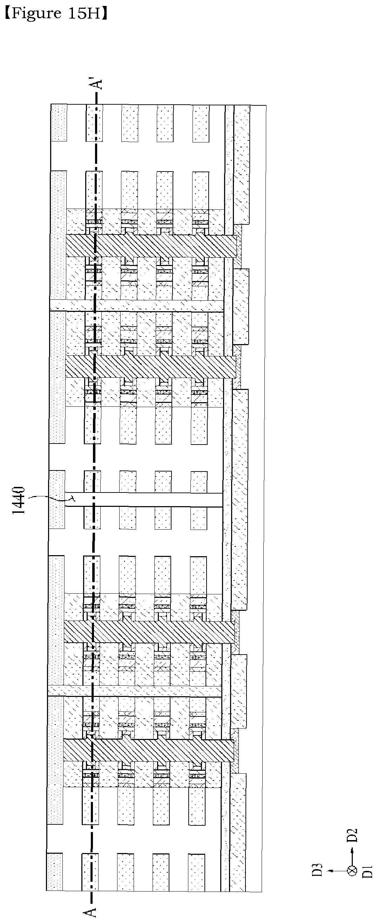

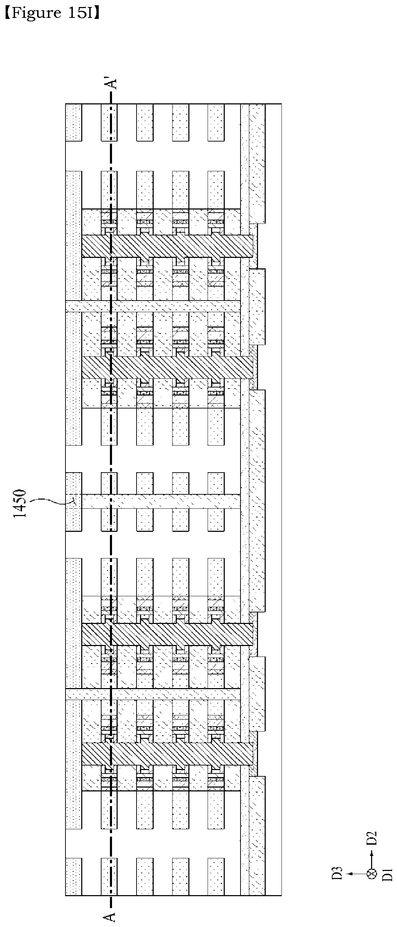

In this regard, the capacitor hole CAPH may be used as a passage through which the wet etching is performed, but the present disclosure may not be limited thereto, and at least one additional hole 1440 and 1450 etched in the semiconductor structure SEMI-STR may be used as shown in FIGS. 14H and 15H and 14I and 15I to secure a process margin.

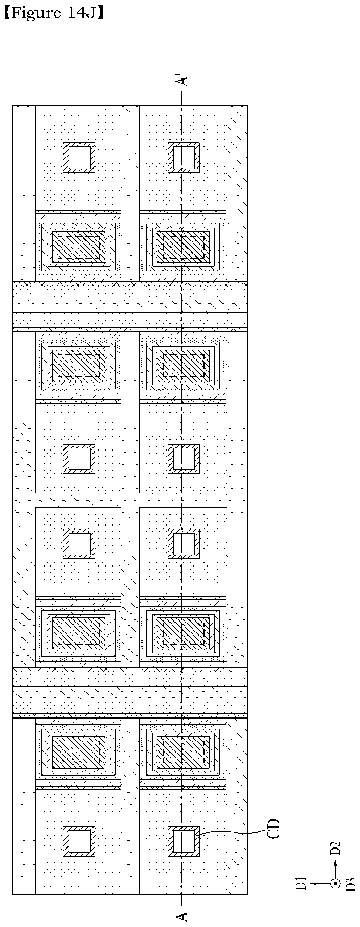

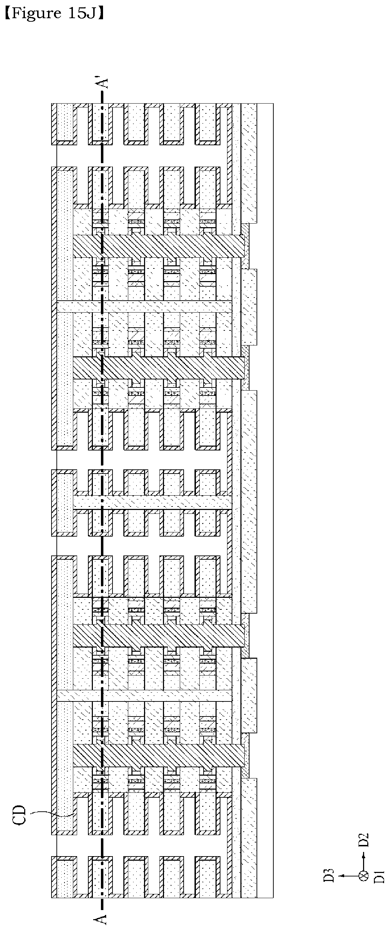

In step S1360, the manufacturing system may deposit the capacitor dielectric film CD with the insulating material the has the insulating properties like the dielectric (e.g., the silicon nitride film, aluminum oxide, hafnium oxide, zirconium oxide, and the like) or the mixture thereof in each of spaces 1430 where remaining portions except for a portion corresponding to the transistor TR in each of the isolated insulating layers ILD were removed and the capacitor hole CAPH as shown in FIGS. 14J and 15J. Because the top surface, the bottom surface, and the side surface of the first electrode EL1 are exposed via each of the spaces 1430, the capacitor dielectric film CD may be formed to cover the top surface, the bottom surface, and the side surface of the first electrode EL1.

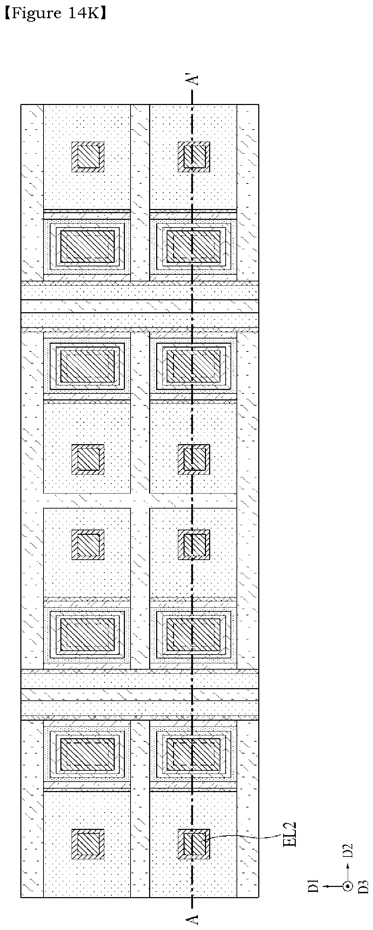

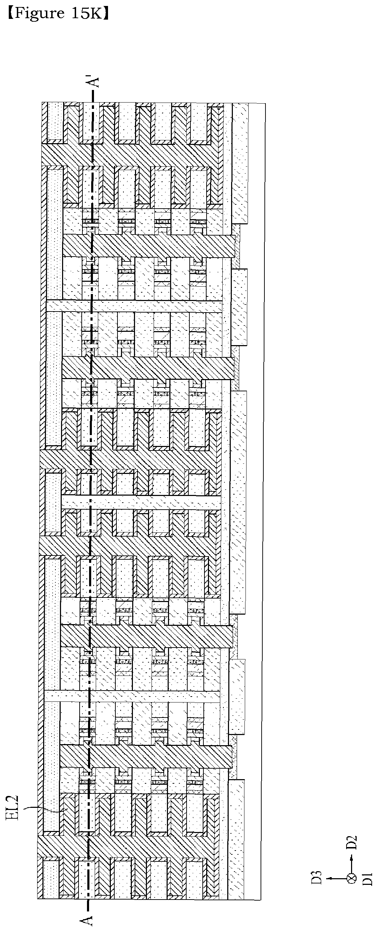

In step S1370, the manufacturing system may form the second electrode EL2 with the semiconductor material (e.g., polysilicon or the like) or the conductive material (e.g., tungsten (W), copper (Cu), aluminum (Al), titanium (Ti), tantalum (Ta), molybdenum (Mo), ruthenium (Ru), gold (Au), titanium nitride, tantalum nitride, and the like) in each of the spaces where the capacitor dielectric film CD was deposited as each of the isolated insulating layers ILD is removed and the capacitor hole CAPH in which the capacitor dielectric film CD was deposited as shown in FIGS. 14K and 15K.

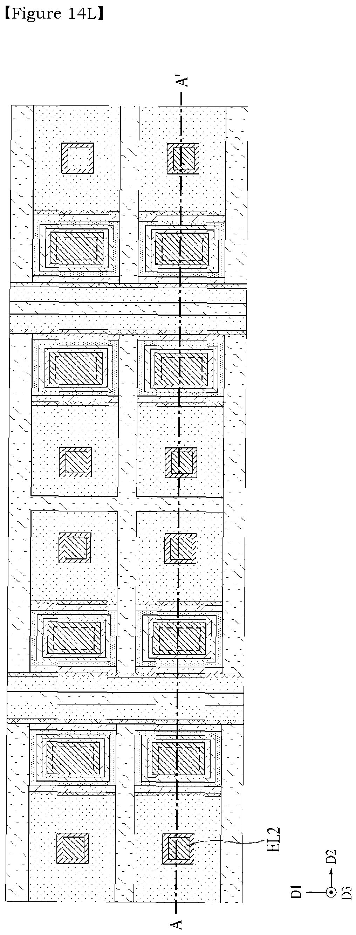

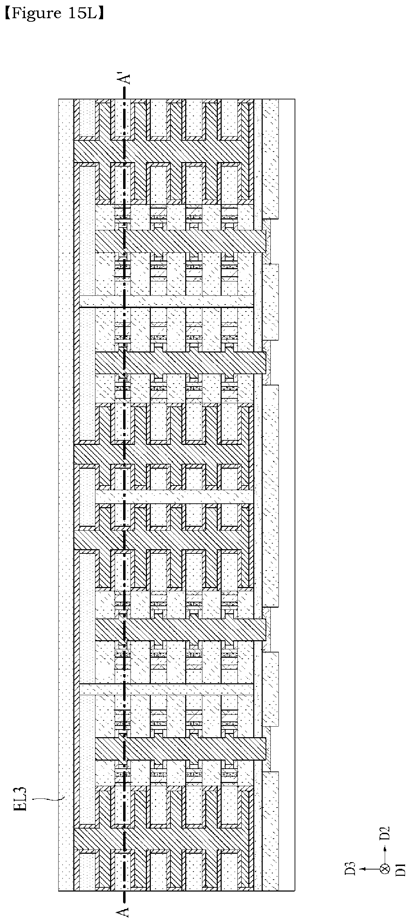

Moreover, after step S1370, the manufacturing system may complete the manufacturing process of the capacitor CAP by depositing an external wiring EL3 electrically connected to the second electrode EL2 on top of the semiconductor structure SEMI-STR as shown in FIGS. 14L and 15L.

As such, as the capacitor dielectric film CD in the capacitor CAP is formed to cover the top surface, the side surface, and the bottom surface of the first electrode EL1 to have the structure of increasing the opposing area size, the required capacitance may be met while improving the integration.

Although the embodiments have been described above based on limited embodiments and drawings, various modifications and variations may be made from the above descriptions by those skilled in the art. For example, the described techniques may be performed in a different order than the described order, and/or, the components of the described system, structure, device, circuit, etc. may be combined with each other in a form different from the described form, or may be replaced with other components or equivalents, such that appropriate results may be achieved.

Therefore, other implementations, other embodiments, and equivalents to the claims fall within the scope of the claims as described below.

## Claims

1. A 3-dimensional memory array including isolated insulating layers and memory cell layers alternately stacked in a vertical direction and individually constructing a transistor and a capacitor, wherein the transistor includes:

   a gate film extending in the vertical direction and protruding in a horizontal direction from each of the isolated insulating layers;
   a channel surrounding at least partial side surface of the gate film in each of the memory cell layers; and
   a source and a drain disposed on both sides of the gate film whose at least partial side surface is surrounded by the channel in each of the memory cell layers,
   wherein the channel, and the source and the drain are made of semiconductor materials with different doping concentrations, respectively.

2. The 3-dimensional memory array of claim 1, wherein the semiconductor material forming the channel and the semiconductor material forming the source and the drain are doped with different types of impurities.

3. The 3-dimensional memory array of claim 1, further comprising:
   a counter doping layer disposed in portions of the source and the drain in contact with the channel, wherein the counter doping layer allows the channel to be easily formed with the semiconductor material having the different doping concentration from the semiconductor material forming the source and the drain.

4. The 3-dimensional memory array of claim 1, further comprising:
   an ohmic film for reducing a contact resistance between the source and the drain and at least one of a bit line in contact with the source and the drain or a first electrode included in the capacitor.

5. The 3-dimensional memory array of claim 1, further comprising:
   a gate insulating film interposed between the gate film and the channel.

6. A 3-dimensional memory array including isolated insulating layers and memory cell layers alternately stacked in a vertical direction and individually constructing a transistor and a capacitor, wherein the capacitor includes:

   a first electrode formed in a horizontal direction in each of the memory cell layers;
   a second electrode extending in the vertical direction and protruding in the horizontal direction in each of the isolated insulating layers; and
a capacitor dielectric film formed to be in contact with the second electrode,
wherein the capacitor dielectric film is formed to be in contact with the second electrode and cover a top surface, a side surface, and a bottom surface of the first electrode.

7. The 3-dimensional memory array of claim 6, wherein the first electrode is electrically connected to a source among the source and a drain included in the transistor in each of the memory cell layers.

8. The 3-dimensional memory array of claim 7, wherein the first electrode is in contact with the source via an ohmic film disposed between the first electrode and the source to reduce a contact resistance.

9. A method for manufacturing a transistor in a 3-dimensional memory array including isolated insulating layers and memory cell layers alternately stacked in a vertical direction, the method comprising:

preparing a semiconductor structure including the isolated insulating layers and the memory cell layers stacked alternately in the vertical direction, wherein each of the memory cell layers is formed with a first semiconductor material, and a gate connection channel, with cells isolated in each of the memory cell layers;
etching a transistor hole in the semiconductor structure in the vertical direction;
recessing each of the memory cell layers in a horizontal direction via the transistor hole;
selectively depositing a second semiconductor material in each of the recessed spaces such that a channel of the transistor is formed with the second semiconductor material;
depositing a gate insulating film in each of the spaces where the second semiconductor material was selectively deposited; and
forming a gate film in each of the spaces where the gate insulating film was deposited and in the transistor hole,
wherein the second semiconductor material forming the channel has a different doping concentration from the first semiconductor material forming a source and a drain of the transistor.

10. The method of claim 9, wherein the second semiconductor material forming the channel and the first semiconductor material forming the source and the drain are doped with different types of impurities.

11. The method of claim 9, wherein the recessing of each of the memory cell layers in the horizontal direction includes:

determining a recess depth based on a thickness of the channel formed with the second semiconductor material in each of the recessed spaces and a horizontal size of the isolated cell in each of the memory cell layers; and
recessing each of the memory cell layers in the horizontal direction based on the determined depth.

12. The method of claim 9, wherein the depositing of the gate insulating film further includes:

depositing the gate insulating film in each of the spaces where the second semiconductor material was selectively deposited and in the transistor hole;
depositing an etching protection film preventing the gate insulating film from being etched in a process of removing an etching stopper included in the semiconductor structure in the spaces where the gate insulating film was deposited and in the transistor hole; and
removing the etching protection film and the gate insulating film deposited in the transistor hole such that the gate insulating film remains only in each of the spaces where the second semiconductor material was selectively deposited and removing the etching stopper using an etchback scheme to expose the gate connection channel included in the semiconductor structure.

13. A method for manufacturing a transistor in a 3-dimensional memory array including isolated insulating layers and memory cell layers alternately stacked in a vertical direction, the method comprising:

preparing a semiconductor structure including the isolated insulating layers and the memory cell layers stacked alternately in the vertical direction, wherein each of the memory cell layers is formed with a first semiconductor material, and a gate connection channel, with cells isolated by a second semiconductor material deposited on a side surface etched in each of the memory cell layers, wherein the second semiconductor material forms a channel of the transistor;
etching a transistor hole in the semiconductor structure in the vertical direction;
recessing each of the memory cell layers in a horizontal direction via the transistor hole;
depositing a gate insulating film in each of the recessed spaces; and
forming a gate film in each of the spaces where the gate insulating film was deposited and in the transistor hole,
wherein the second semiconductor material forming the channel has a different doping concentration from the first semiconductor material forming a source and a drain of the transistor.

14. The method of claim 13, wherein the second semiconductor material forming the channel and the first semiconductor material forming the source and the drain are doped with different types of impurities.

15. The method of claim 13, wherein the recessing of each of the memory cell layers in the horizontal direction includes:

   determining a recess depth such that the second semiconductor material is exposed in each of the recessed spaces based on a horizontal size of the isolated cell in each of the memory cell layers; and
   recessing each of the memory cell layers in the horizontal direction based on the determined depth.

16. The method of claim 13, wherein the depositing of the gate insulating film further includes:

   depositing the gate insulating film in each of the recessed spaces and in the transistor hole;
   depositing an etching protection film preventing the gate insulating film from being etched in a process of removing an etching stopper included in the semiconductor structure in the spaces where the gate insulating film was deposited and in the transistor hole; and
   removing the etching protection film and the gate insulating film deposited in the transistor hole such that the gate insulating film remains only in each of the recessed spaces and removing the etching stopper using an etchback scheme to expose the gate connection channel included in the semiconductor structure.

17. The method of one of claims 9 or 13, further comprising:

   etching a bit line hole or a bit line bar in the vertical direction in an area between the isolated cells in the semiconductor structure;
   recessing spaces in each of the memory cell layers in the horizontal direction via the bit line hole or the bit line bar; and
   forming a bit line in each of the recessed spaces.

18. A method for manufacturing a capacitor in a 3-dimensional memory array including isolated insulating layers and memory cell layers alternately stacked in a vertical direction, the method comprising:

   preparing a semiconductor structure including the isolated insulating layers and the memory cell layers stacked alternately in the vertical direction, wherein each of the memory cell layers is formed with a first semiconductor material, and a gate connection channel, with cells isolated in each of the memory cell layers;
   etching a capacitor hole in the semiconductor structure in the vertical direction;
   removing remaining portions except for the first semiconductor material forming a source and a drain of a transistor manufactured in the semiconductor structure in each of the memory cell layers via the capacitor hole;
   depositing a first electrode in spaces where the remaining portions were removed;
   removing remaining portions except for a portion corresponding to the transistor in each of the isolated insulating layers such that a surface of the first electrode formed in each of the memory cell layers is exposed;
   depositing a capacitor dielectric film in each of the spaces where the remaining portions except for the portion corresponding to the transistor were removed in each of the isolated insulating layers and in the capacitor hole; and
   forming a second electrode in each of the spaces where the isolated insulating layers was removed and the capacitor dielectric film was deposited and in the capacitor hole where the capacitor dielectric film was deposited,
   wherein the capacitor dielectric film is formed to be in contact with the second electrode and cover a top surface, a side surface, and a bottom surface of the first electrode.

19. The method of claim 18, wherein the etching of the capacitor hole in the vertical direction includes etching the capacitor hole in the vertical direction at an arbitrary location on the semiconductor structure in consideration of a thickness of the source included in the transistor manufactured in the semiconductor structure.

20. The method of claim 18, wherein the depositing of the first electrode includes:

   forming an ohmic film for reducing a contact resistance with the first semiconductor material forming the source and the drain of the transistor in each of the spaces where the remaining portions were removed; and
   depositing the first electrode in each of the spaces where the ohmic film was formed.

【Figure 1】

【Figure 2A】

【Figure 2B】

TR

【Figure 3】

CAP

EL2

EL1

CD

D3

D1

D2

【Figure 4】

【Figure 5】

【Figure 6】

```
                        ┌─────────┐
                        │  Start  │
                        └─────────┘
                             │
                             ▼
        ┌──────────────────────────────────────────┐
        │      Prepare semiconductor structure      │ ──── S610
        └──────────────────────────────────────────┘
                             │
                             ▼
        ┌──────────────────────────────────────────┐
        │      Etch transistor hole in vertical     │ ──── S620
        │                direction                  │
        └──────────────────────────────────────────┘
                             │
                             ▼
        ┌──────────────────────────────────────────┐
        │   Recess each of memory cell layers in    │ ──── S630
        │   horizontal direction via transistor hole│
        └──────────────────────────────────────────┘
                             │
                             ▼
        ┌──────────────────────────────────────────┐
        │  Selectively deposit second semiconductor │
        │  material in each of recessed spaces such │ ──── S640
        │  that channel of transistor is formed with│
        │       second semiconductor material       │
        └──────────────────────────────────────────┘
                             │
                             ▼
        ┌──────────────────────────────────────────┐
        │ Deposit gate insulating film in each of   │ ──── S650
        │ spaces where second semiconductor material│
        │        was selectively deposited          │
        └──────────────────────────────────────────┘
                             │
                             ▼
        ┌──────────────────────────────────────────┐
        │ Form gate film in each of spaces where    │ ──── S660
        │ gate insulating film was deposited and in │
        │              transistor hole              │
        └──────────────────────────────────────────┘
                             │
                             ▼
                        ┌─────────┐
                        │   End   │
                        └─────────┘
```

【Figure 7A】

【Figure 7B】

A'

A

First semiconductor material

ILD

D1
D2
D3

【Figure 7C】

【Figure 7D】

【Figure 7E】

【Figure 7F】

730

【Figure 7G】

[Figure 7H]

Second semiconductor
material

740

D1

D2

D3

A — A'

EP 4 432 802 A1

【Figure 7I】

【Figure 7J】

【Figure 7K】

【Figure 7L】

【Figure 7M】

【Figure 7N】

【Figure 7O】

【Figure 7P】

【Figure 8A】

【Figure 8B】

【Figure 8C】

【Figure 8D】

【Figure 8E】

【Figure 8F】

【Figure 8G】

【Figure 8H】

Second semiconductor material

740

D3
D2
D1

【Figure 8I】

【Figure 8J】

【Figure 8K】

【Figure 8L】

【Figure 8M】

【Figure 8N】

【Figure 8O】

【Figure 8P】

【Figure 9】

```
                        ┌──────────┐
                        │  Start   │
                        └────┬─────┘
                             │
                             ▼
    ┌──────────────────────────────────────────────┐
    │       Prepare semiconductor structure        │ ─── S910
    └───────────────────────┬──────────────────────┘
                             │
                             ▼
    ┌──────────────────────────────────────────────┐
    │      Etch transistor hole in vertical         │ ─── S920
    │                 direction                     │
    └───────────────────────┬──────────────────────┘
                             │
                             ▼
    ┌──────────────────────────────────────────────┐
    │    Recess each of memory cell layers in       │ ─── S930
    │   horizontal direction via transistor hole    │
    └───────────────────────┬──────────────────────┘
                             │
                             ▼
    ┌──────────────────────────────────────────────┐
    │  Deposit gate insulating film in each of      │ ─── S940
    │            recessed spaces                    │
    └───────────────────────┬──────────────────────┘
                             │
                             ▼
    ┌──────────────────────────────────────────────┐
    │ Form gate film in each of spaces where gate   │ ─── S950
    │ insulating film was deposited and in          │
    │              transistor hole                  │
    └───────────────────────┬──────────────────────┘
                             │
                             ▼
                        ┌──────────┐
                        │   End    │
                        └──────────┘
```

【Figure 10A】

SEMI-STR

First semiconductor material

Second semiconductor material

A

A'

D1

D2

D3

【Figure 10B】

【Figure 10C】

【Figure 10D】

【Figure 10E】

【Figure 10F】

【Figure 10G】

【Figure 11A】

【Figure 11B】

【Figure 11C】

【Figure 11D】

【Figure 11E】

【Figure 11F】

【Figure 11G】

【Figure 12】

【Figure 13】

```
                    ┌─────────┐
                    │  Start  │
                    └────┬────┘
                         ▼
┌────────────────────────────────────────────┐
│       Prepare semiconductor structure       │────  S1310
└────────────────────────────────────────────┘
                         ▼
┌────────────────────────────────────────────┐
│       Etch capacitor hole in vertical       │────  S1320
│                 direction                    │
└────────────────────────────────────────────┘
                         ▼
┌────────────────────────────────────────────┐
│ Remove remaining portions except for first   │
│ semiconductor material that forms source and │────  S1330
│ drain in each of memory cell layers via      │
│ capacitor hole                               │
└────────────────────────────────────────────┘
                         ▼
┌────────────────────────────────────────────┐
│ Deposit first electrode in spaces where      │
│ remaining portions were removed              │────  S1340
└────────────────────────────────────────────┘
                         ▼
┌────────────────────────────────────────────┐
│ Remove remaining portions except for portion │
│ corresponding to transistor in each of       │────  S1350
│ isolated insulating layers such that surface │
│ of first electrode in each of memory cell    │
│ layers is exposed                            │
└────────────────────────────────────────────┘
                         ▼
┌────────────────────────────────────────────┐
│ Deposit capacitor dielectric film in each of │
│ spaces where remaining portions except for   │────  S1360
│ portion corresponding to transistor in each  │
│ of isolated insulating layers were removed   │
│ and capacitor hole                           │
└────────────────────────────────────────────┘
                         ▼
┌────────────────────────────────────────────┐
│ Form second electrode in each of spaces      │
│ where capacitor dielectric film was          │────  S1370
│ deposited as each of isolated insulating     │
│ layers is removed and capacitor hole in      │
│ which capacitor dielectric film was deposited │
└────────────────────────────────────────────┘
                         ▼
                    ┌─────────┐
                    │   End   │
                    └─────────┘
```

【Figure 14A】

EP 4 432 802 A1

[Figure 14B]

CAPH

D1
D2
D3

【Figure 14C】

【Figure 14D】

【Figure 14E】

【Figure 14F】

【Figure 14G】

【Figure 14H】

【Figure 14I】

【Figure 14J】

【Figure 14K】

【Figure 14L】

【Figure 15A】

【Figure 15B】

【Figure 15C】

【Figure 15D】

【Figure 15E】

【Figure 15F】

【Figure 15G】

1430

A A'

D3 D2 D1

【Figure 15H】

【Figure 15I】

【Figure 15J】

【Figure 15K】

【Figure 15L】

## INTERNATIONAL SEARCH REPORT

| International application No. |
| --- |
| **PCT/KR2022/010184** |

**A. CLASSIFICATION OF SUBJECT MATTER**

**H01L 27/108**(2006.01)i

According to International Patent Classification (IPC) or to both national classification and IPC

**B. FIELDS SEARCHED**

Minimum documentation searched (classification system followed by classification symbols)

H01L 27/108(2006.01); H01L 27/115(2006.01); H01L 27/11524(2017.01); H01L 27/11556(2017.01); H01L 27/11582(2017.01); H01L 29/78(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 트랜지스터(transistor), 3차원 메모리(3D memory), 절연층(insulation layer), 반도체(semiconductor), 채널(channel)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0014442 A (MICRON TECHNOLOGY, INC.) 10 February 2020 (2020-02-10)<br>See paragraphs [0010]-[0011], [0013]-[0014] and [0026]; claims 1 and 26; and figures 2-3 and 11. | 1-20 |
| A | KR 10-2002-0077215 A (NEC ELECTRONICS CORPORATION) 11 October 2002 (2002-10-11)<br>See paragraphs [0035]-[0091]; and figures 2-3 and 9. | 1-20 |
| A | KR 10-2008-0052020 A (SAMSUNG ELECTRONICS CO., LTD.) 11 June 2008 (2008-06-11)<br>See paragraph [0037]; and figure 1. | 1-20 |
| A | KR 10-2012-0035468 A (SAMSUNG ELECTRONICS CO., LTD.) 16 April 2012 (2012-04-16)<br>See paragraphs [0116]-[0123]; and figures 37-39. | 1-20 |
| A | KR 10-2020-0039813 A (MICRON TECHNOLOGY, INC.) 16 April 2020 (2020-04-16)<br>See paragraph [0027]; and figure 1. | 1-20 |

☐ Further documents are listed in the continuation of Box C.  ☑ See patent family annex.

| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| --- | --- |
| Date of the actual completion of the international search<br><br>**31 October 2022** | Date of mailing of the international search report<br><br>**01 November 2022** |
| Name and mailing address of the ISA/KR<br><br>**Korean Intellectual Property Office<br>Government Complex-Daejeon Building 4, 189 Cheongsa-ro, Seo-gu, Daejeon 35208** | Authorized officer |
| Facsimile No. **+82-42-481-8578** | Telephone No. |

Form PCT/ISA/210 (second sheet) (July 2022)

# EP 4 432 802 A1

<table>
<tr><td colspan="2"><strong>INTERNATIONAL SEARCH REPORT</strong><br>Information on patent family members</td><td>International application No.<br><br><strong>PCT/KR2022/010184</strong></td></tr>
</table>

| Patent document cited in search report | | | Publication date (day/month/year) | Patent family member(s) | | | Publication date (day/month/year) |
|---|---|---|---|---|---|---|---|
| KR | 10-2020-0014442 | A | 10 February 2020 | CN | 110800107 | A | 14 February 2020 |
| | | | | EP | 3646379 | A1 | 06 May 2020 |
| | | | | KR | 10-2401865 | B1 | 25 May 2022 |
| | | | | US | 11011529 | B2 | 18 May 2021 |
| | | | | US | 2019-0006376 | A1 | 03 January 2019 |
| | | | | US | 2021-0242226 | A1 | 05 August 2021 |
| | | | | WO | 2019-005651 | A1 | 03 January 2019 |
| KR | 10-2002-0077215 | A | 11 October 2002 | JP | 2002-299609 | A | 11 October 2002 |
| | | | | KR | 10-0486187 | B1 | 03 May 2005 |
| | | | | US | 2002-0140044 | A1 | 03 October 2002 |
| | | | | US | 2004-0014262 | A1 | 22 January 2004 |
| | | | | US | 6638801 | B2 | 28 October 2003 |
| | | | | US | 6943400 | B2 | 13 September 2005 |
| KR | 10-2008-0052020 | A | 11 June 2008 | CN | 101197379 | A | 11 June 2008 |
| | | | | CN | 101197379 | B | 06 April 2011 |
| | | | | CN | 101197379 | C | 11 June 2008 |
| | | | | JP | 2008-147664 | A | 26 June 2008 |
| | | | | KR | 10-0876082 | B1 | 26 December 2008 |
| | | | | US | 2008-0135912 | A1 | 12 June 2008 |
| | | | | US | 2010-0327371 | A1 | 30 December 2010 |
| | | | | US | 7808036 | B2 | 05 October 2010 |
| | | | | US | 8334562 | B2 | 18 December 2012 |
| KR | 10-2012-0035468 | A | 16 April 2012 | JP | 2012-080105 | A | 19 April 2012 |
| | | | | KR | 10-1825539 | B1 | 22 March 2018 |
| | | | | US | 2012-0083077 | A1 | 05 April 2012 |
| | | | | US | 2013-0065369 | A1 | 14 March 2013 |
| | | | | US | 8309405 | B2 | 13 November 2012 |
| | | | | US | 8815676 | B2 | 26 August 2014 |
| KR | 10-2020-0039813 | A | 16 April 2020 | CN | 111052377 | A | 21 April 2020 |
| | | | | EP | 3679605 | A1 | 15 July 2020 |
| | | | | EP | 3679605 | B1 | 14 April 2021 |
| | | | | KR | 10-2378401 | B1 | 24 March 2022 |
| | | | | US | 10804273 | B2 | 13 October 2020 |
| | | | | US | 2019-0074277 | A1 | 07 March 2019 |
| | | | | US | 2020-0388617 | A1 | 10 December 2020 |
| | | | | WO | 2019-050805 | A1 | 14 March 2019 |

Form PCT/ISA/210 (patent family annex) (July 2022)

**EP 4 432 802 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190006376 A